(19) Europäisches Patentamt
European Patent Office
Office européen des brevets

(11) Veröffentlichungsnummer: **0 234 570 B1**

(12) # EUROPÄISCHE PATENTSCHRIFT

(45) Veröffentlichungstag der Patentschrift: **22.04.92**

(51) Int. Cl.[5]: **G03C 1/72**

(21) Anmeldenummer: **87102689.4**

(22) Anmeldetag: **25.02.87**

(54) **Photopolymersierbares Gemisch, dieses enthaltendes lichtempfindliches Aufzeichnungselement sowie Verfahren zur Herstellung einer Flachdruckform mittels dieses lichtempfindliches Aufzeichnungselements.**

(30) Priorität: **26.02.86 DE 3606155**

(43) Veröffentlichungstag der Anmeldung:
**02.09.87 Patentblatt 87/36**

(45) Bekanntmachung des Hinweises auf die Patenterteilung:
**22.04.92 Patentblatt 92/17**

(84) Benannte Vertragsstaaten:
**AT BE CH DE ES FR GB IT LI NL SE**

(56) Entgegenhaltungen:
**EP-A- 0 127 762**
**DE-A- 1 952 804**
**DE-A- 2 851 641**
**DE-A- 3 339 228**
**FR-A- 2 296 658**
**GB-A- 2 029 428**
**GB-A- 2 095 248**
**US-A- 3 987 037**
**US-A- 4 259 432**

(73) Patentinhaber: **BASF Akfiengesellschaft**
**Carl-Bosch-Strasse 38**
**W-6700 Ludwigshafen(DE)**

(72) Erfinder: **Hoffmann,Gerhard,Dr.**
**Pappelstrasse 22**
**W-6701 Otterstadt(DE)**
Erfinder: **Hofmann,Reiner,Dr.**
**Mandelbergstrasse 44**
**W-6730 Neustadt(DE)**
Erfinder: **Lauke, Harald, Dr.**
**D. 3,2**
**W-6800 Mannheim 1(DE)**
Erfinder: **Weber, Wilhelm, Dr.**
**Mandelbergstrasse 40**
**W-6730 Neustadt(DE)**
Erfinder: **Leyrer, Reinhold J., Dr.**
**Menzelstrasse 4**
**W-6700 Ludwigshafen(DE)**

EP 0 234 570 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein neues photopolymerisierbares Gemisch mit verbesserter Photoempfindlichkeit, enthaltend mindestens eine ethylenisch ungesättigte photopolymerisierbare Verbindung sowie ein Photoinitiator-System. Die Erfindung betrifft ferner ein lichtempfindliches Aufzeichnungselement, wie es insbesondere für die optische Informationsfixierung und in der Reproduktionstechnik verwendet wird, mit einer lichtempfindlichen Schicht auf Basis dieses neuen photopolymerisierbaren Gemisches. Desweiteren betrifft die Erfindung ein Verfahren zur Herstellung einer Flachdruckform mittels eines solchen lichtempfindlichen Aufzeichnungselements.

Photopolymerisierbare Gemische finden eine breite Anwendung, beispielsweise bei der Herstellung von lichthärtbaren Überzügen, Lacken, Druckfarben, Schutz- und Resistschichten, photopolymeren Druckformen, Kopierfilmen und dergleichen. Eine wesentliche Anforderung an diese photopolymerisierbaren Gemische ist, daß sie eine möglichst hohe Photoempfindlichkeit besitzen, d.h. daß die bei der Bestrahlung mit aktinischem Licht induzierte Photopolymerisation bzw. Photohärtung, unabhängig von sonstigen Einflüssen, möglichst rasch abläuft. Dieses Erfordernis gilt insbesondere beim Einsatz der photopolymerisierbaren Gemische für die optische Informationsfixierung und in der Reproduktionstechnik, da hier die Dauer der Photopolymerisation maßgeblich die gesamte Verarbeitungszeit beeinflußt.

Die Photopolymerisationseigenschaften der photopolymerisierbaren Gemische werden maßgeblich von dem Photopolymerisationsinitiator mitbestimmt. Als Photoinitiatoren, die bei Bestrahlung mit aktinischem Licht die Polymerisation der ethylenisch ungesättigten Verbindungen in den photopolymerisierbaren Gemischen zu initiieren vermögen, wurden bereits eine Vielzahl von Verbindungen vorgeschlagen. Hierzu gehören beispielsweise Benzoinether, Benzilketale, Benzoylacylphosphinoxid-Verbindungen, mehrkernige Chinone, wie Anthrachinon und seine Derivate, Benzophenon und seine Derivate, Thioxanthone, mindestens eine Halogenmethyl-Gruppe enthaltende s-Triazin-Derivate, Hexaarylbisimidazole und andere. Eine Zusammenstellung einer Vielzahl von photopolymerisierbaren Systemen mit den verschiedensten Photoinitiatoren findet sich beispielsweise in dem Artikel "Photopolymersysteme und ihre Anwendungen" von H.-J.Timpe und H.Baumann, Chemische Technik 36 (1984), S. 1 bis 7. Zur Verbesserung der Photoempfindlichkeit der photopolymerisierbaren Gemische ist auch schon vorgeschlagen worden, Kombinationen von Photoinitiatoren bzw. von einem Photoinitiator und einem Sensibilisierungsmittel zu verwenden. Ein bekanntes und sehr breit angewandtes Photoinitiator-System dieser Art ist die Kombination von Benzophenon und Michlers Keton (vgl. u.a. DE-A-1 522 359). Im allgemeinen werden Amino-Gruppen enthaltende Verbindungen als Sensibilisatoren für Photoinitiatoren eingesetzt (vgl. z.B. EP-A-138 187 und GB-A-2 083 832). Ferner sind, beispielsweise in der DE-A-2 934 758, der US-A-4 239 850 und der JP-A-55050001, Mischungen von mindestens eine Halogenmethyl-Gruppe enthaltenden s-Triazinen mit bestimmten Dialkylamino-Gruppen enthaltenden aromatischen Carbonylverbindungen bzw. N-heteroaromatischen Carbonylverbindungen als Photoinitiator-Kombination beschrieben worden. Dennoch besteht nach wie vor ein Bedarf, die Photoempfindlichkeit von photopolymerisierbaren Gemischen zu steigern und insbesondere auch die Empfindlichkeit dieser photopolymerisierbaren Gemische gegenüber dem inhibierenden Einfluß von Sauerstoff herabzusetzen.

Aus der FR-A-2 296 658 sind photopolymerisierbare Zusammensetzungen bekannt, die als Photopolymerisationsinitiatoren Thioxanthone in Verbindung mit Mono- und Diazinen enthalten.

In der DE-A-3 037 521 wird eine photopolymerisierbare Masse beschrieben, die eine ethylenisch ungesättigte, photopolymerisierbare Verbindung, ein polymeres Bindemittel, einen Photopolymerisationsinitiator sowie eine Aminogruppen enthaltende s-Triazin-Verbindung enthält. Als Photopolymerisationsinitiator werden unter anderem Anthrachinon und dessen Derivate, Benzophenon und Benzophenon-Derivate, wie Michlers Keton, sowie Kombinationen dieser Verbindungen genannt. Die aminogruppenhaltige s-Triazin-Verbindung dient hier der Haftungsverbesserung der photopolymerisierbaren Masse auf einem Substrat.

Zur Unterdrückung der Sauerstoff-Inhibierung bei der Photopolymerisation ist auch schon vorgeschlagen worden, den photopolymerisierbaren Gemischen Sauerstoffänger zuzumischen. Hierdurch kann häufig ein positiver Einfluß auf die Photopolymerisation erzielt werden. Beispielsweise ist 1,3-Diphenylisobenzofuran ein effizienter Sauerstoffänger für bestimmte photopolymerisierbare Gemische (vgl. z.B. Photographic Sci.Eng. 23 (1979), S. 137 bis 140).

Die Photoempfindlichkeit der bekannten photopolymerisierbaren Gemische wird im Hinblick auf die gestiegenen Anforderungen und neueren Verarbeitungstechniken zunehmend als zu gering beurteilt. Gerade bei der Verarbeitung von lichtempfindlichen, photopolymerisierbaren Aufzeichnungselementen in der Reproduktionstechnik sind die Belichtungszeiten häufig die geschwindigkeitsbestimmende Größe. Auch ist bislang kein photopolymerisierbares Gemisch bekannt, das die Bedingungen für eine Kamera-Belichtung erfüllt, wie sie gerade im Bereich der Herstellung von Flachdruckplatten von hohem Interesse ist. Durch die

digitale Informationsverarbeitung werden zudem lichtempfindliche Aufzeichnungselemente mit schnelleren Photopolymerisations-Geschwindigkeiten gewünscht, die z.B. einer Laser-Belichtung zugänglich sind. Auch wenn durch den Zusatz von Sauerstoffängern die Inhibierung der Photopolymerisation in den photopolymerisierbaren Gemischen durch Sauerstoff in gewissem Umfang reduziert werden kann, wird in der Praxis nach wie vor die photopolymerisierbare Schicht von lichtempfindlichen Aufzeichnungselementen mit einer sauerstoffsperrenden Deckschicht versehen. Solche Deckschichten wirken jedoch im Fall von lichtempfindlichen Aufzeichnungselementen mit dünnen photopolymerisierbaren Schichten, wie sie unter anderem bei der Herstellung von Resistschichten und Flachdruckformen eingesetzt werden, wo die sauerstoffsperrende Deckschicht in aller Regel dicker ist als die photopolymerisierbare Schicht der lichtempfindlichen Aufzeichnungselemente, auflösungsvermindernd.

Der vorliegenden Erfindung lag die Aufgabe zugrunde, neue photopolymerisierbare Gemische mit sehr hoher Photoempfindlichkeit zur Verfügung zu stellen. Aufgabe der Erfindung war es weiterhin, neue photopolymerisierbare Gemische mit verbesserter Photoempfindlichkeit zu schaffen, bei denen die Inhibierung der Photopolymerisation durch Sauerstoff deutlich verringert ist. Die neuen photopolymerisierbaren Gemische sollen sich dabei insbesondere für die Herstellung von hochauflösenden lichtempfindlichen Aufzeichnungselementen mit dünnen photopolymerisierbaren Schichten eignen, wie sie beispielsweise für die Herstellung von Resistfilmen und Flachdruckformen Verwendung finden, die bei kurzen Belichtungszeiten eine exakte Bild- und Tonwertwiedergabe selbst feiner und feinster Bildelemente gestatten.

Es wurde nun überraschend gefunden, daß diese Aufgabe durch solche photopolymerisierbaren Gemische gelöst wird, die neben mindestens einer ethylenisch ungesättigten, photopolymerisierbaren Verbindung sowie gegebenenfalls weiteren Zusatz- und/oder Hilfsstoffen als Photopolymerisationsinitiator eine Mischung aus mindestens einer Verbindung der nachstehend angegebenen allgemeinen Formel (I), insbesondere Benzophenon, Benzophenon-Derivaten, Anthrachinon und Anthrachinon-Derivaten sowie Xanthon- und Thioxanthon-Verbindungen, und mindestens einer s-Triazin-Verbindung mit mindestens einer durch Halogen substituierten Methylgruppe enthalten.

Gegenstand der vorliegenden Erfindung sind dementsprechend photopolymerisierbare Gemische, enthaltend mindestens eine ethylenisch ungesättigte, photopolymerisierbare oder photovernetzbare Verbindung sowie einen Photopolymerisationsinitiator, welche dadurch gekennzeichnet sind, daß der Photopolymerisationsinitiator eine Kombination umfaßt von

a) einer Verbindung der allgemeinen Formel (I)

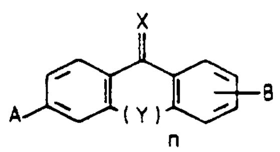

(I),

worin bedeuten

A ein Wasserstoffatom, eine gegebenenfalls substituierte Alkylgruppe, eine $-NR^1R^2$-Gruppe (mit $R^1$, $R^2$ gleich oder verschieden und unabhängig voneinander einem Wasserstoffatom oder einem, gegebenenfalls substituierten, aliphatischen, aromatischen oder gemischt aliphatisch-aromatischen Rest) oder eine $-OR^3$-Gruppe (mit $R^3$ gleich einem Wasserstoffatom oder einem, gegebenenfalls substituierten, aliphatischen, aromatischen oder gemischt aliphatisch-aromatischen Rest),

B einen Rest der unter A genannten Art (wobei die Reste A und B untereinander gleich oder verschieden sein können), ein Halogenatom oder die $-C{\equiv}N$-Gruppe,

X ein Sauerstoffatom, ein Schwefelatom oder eine $=NR^4$-Gruppe (mit $R^4$ gleich einem Wasserstoffatom oder einem aliphatischen, aromatischen oder gemischt aliphatisch-aromatischen Rest),

Y eine direkte Bindung, eine $-CH_2-$, $-CH_2-CH_2-$, -O-, -S-, -C(O)- oder $-NR^5$-Gruppierung (mit $R^5$ gleich einem Wasserstoffatom oder einem aliphatischen oder aromatischen Rest) und

n 0 oder die Zahl 1,

und

b) mindestens einer Verbindung der allgemeinen Formel (II)

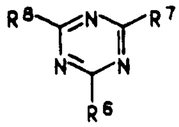

(II),

worin bedeuten

$R^6$, $R^7$, $R^8$ gleich oder verschieden und jeweils für sich eine gegebenenfalls substituierte Alkylgruppe, eine gegebenenfalls substituierte Arylgruppe oder eine gegebenenfalls substituierte Aralkylgruppe, wobei mindestens einer der Reste $R^6$ bis $R^8$ eine mono-, di- oder trihalogensubstituierte Methylgruppe darstellt und einer der Reste $R^6$, $R^7$ oder $R^8$ auch eine gegebenenfalls substituierte Alkenylgruppe, eine -$NR_2$-, -OR- oder -SR-Gruppe sein kann, wobei der Rest R jeweils für ein Wasserstoffatom, eine Alkyl-oder eine Arylgruppe steht.

Als gegebenenfalls substituierte Alkenylgruppen $R^8$ kommen vorzugsweise Styrylgruppen der allgemeinen Formel

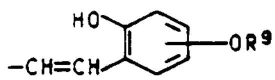

worin $R^9$ für Wasserstoff, eine Alkylgruppe, z.B. eine Alkylgruppe mit 1 bis 4, vorzugsweise 1 oder 2 Kohlenstoffatomen, oder eine Arylgruppe, wie z.B. eine Phenylgruppe steht, in Betracht.

Gegenstand der Erfindung ist weiterhin ein lichtempfindliches Aufzeichnungselement, insbesondere für die Herstellung von Druckformen oder Resistmustern, mit einer auf einem dimensionsstabilen Träger aufgebrachten lichtempfindlichen Aufzeichnungsschicht, welches dadurch gekennzeichnet ist, daß die lichtempfindliche Aufzeichnungsschicht aus einem erfindungsgemäßen photopolymerisierbaren Gemisch der vorstehend genannten Art gebildet wird. Gegenstand der Erfindung ist darüber hinaus ein Verfahren zur Herstellung von Druckformen oder Resistmustern, insbesondere Flachdruckformen, unter Verwendung eines erfindungsgemäßen lichtempfindlichen Aufzeichnungselementes, wie es nachfolgend näher erläutert ist. Bevorzugte und spezielle Ausgestaltungsformen der Erfindung ergeben sich ebenfalls aus der nachfolgenden, detaillierten Beschreibung.

Die neuen, erfindungsgemäßen photopolymerisierbaren Gemische und die damit hergestellten lichtempfindlichen Aufzeichnungselemente zeichnen sich durch ihre hohe Photoempfindlichkeit aus. Obwohl die Verbindungen der allgemeinen Formel (I) und der allgemeinen Formel (II), jeweils für sich genommen, an sich bekannte Photopolymerisationsinitiatoren für photopolymerisierbare Gemische sind, hat es sich überraschenderweise gezeigt, daß die Photoempfindlichkeit der photopolymerisierbaren Gemische durch die Verwendung der erfindungsgemäßen Kombination dieser Verbindungen als Photoinitiator synergistisch gesteigert wird. Gleichzeitig wird die inhibierende Wirkung des Sauerstoffs im Vergleich zu den bekannten photopolymerisierbaren Gemischen erheblich reduziert, als auch zeigen die lichtempfindlichen Aufzeichnungselemente auf Basis der neuen erfindungsgemäßen photopolymerisierbaren Gemische, die auch ohne spezielle Sauerstoff-Sperrschichten für die Herstellung von Druckformen oder Resistmustern verwendet werden können, ein sehr gutes, verbessertes Auflösungsvermögen.

Als Komponente a) der erfindungsgemäß zu verwendenden Photoinitiator-Kombination kommen alle an sich als Photoinitiatoren bekannten und wirksamen Verbindungen der vorstehend angegebenen allgemeinen Formel (I) in Betracht. Wenn A und/oder B in der allgemeinen Formel (I) für eine -$NR^1R^2$-Gruppe stehen, stellen $R^1$ und $R^2$, unabhängig voneinander, vorzugsweise ein Wasserstoffatom, eine Alkyl-Gruppe insbesondere mit 1 bis 4 C-Atomen, eine Hydroxyalkyl-Gruppe insbesondere mit 2 bis 3 C-Atomen oder einen Phenylrest dar. Die Reste $R^1$ und $R^2$ können dabei auch unter Ausbildung eines 5-oder 6-gliedrigen, heterocyclischen Ringes miteinander verknüpft sein. Für den Fall, daß A und/oder B in der allgemeinen Formel (I) eine -$OR^3$-Gruppe bedeuten, steht $R^3$ vorzugsweise für ein Wasserstoffatom, eine Alkylgruppe insbesondere mit 1 bis 8 Kohlenstoffatomen oder einen Phenylrest. A und/oder B können in der allgemeinen Formel (I) auch einen gegebenenfalls substituierten Alkylrest, insbesondere mit 1 bis 8 Kohlenstoffatomen, darstellen. Beispiele für die Substituenten A und B in der allgemeinen Formel (I) sind unter anderem ein Wasserstoffatom, eine Dialkylamino-Gruppe, insbesondere Dimethylamino oder Diethylamino, eine N-Alkyl-N-hydroxyalkylamino-Gruppe, wie unter anderem die N-Ethyl-N-hydroxyethyl-amino-Gruppe, der Hydroxy-Rest, eine Alkoxy-Gruppe, wie etwa Methoxy oder Ethoxy, eine Alkyl-Gruppe mit 1 bis 4 C-Atomen, wie Methyl, Ethyl, i-Butyl oder t-Butyl, oder auch Halogenalkyl, wie Chlormethyl oder Dichlormethyl. B kann darüber hinaus für ein Halogenatom, insbesondere ein Chloratom oder Bromatom, oder auch für die Nitrilgruppe stehen. X stellt in der allgemeinen Formel (I) vorzugsweise ein Sauerstoffatom oder in dem Fall, daß X für eine $=NR^4$-Gruppe steht, eine =NH-Gruppe dar. Ist in der allgemeinen Formel (I) n = 1, d.h., ist eine die beiden Phenylringe verbindende Gruppierung Y vorhanden, dann handelt es sich hierbei vorzugsweise um ein Sauerstoffatom, ein Schwefelatom oder die Carbonyl-Gruppierung. Für den Fall, daß in der allgemeinen Formel (I) n = 0 ist, also keine die beiden Phenylringe verbindende Gruppierung Y vorhanden ist, sind die beiden C-Atome der Phenylringe, an denen im anderen Fall die überbrückende Gruppierung Y gebunden ist, durch jeweils ein Wasserstoffatom abgesättigt.

Zu den Verbindungen der allgemeinen Formel (I) gehören Benzophenon, Fluorenon, Anthrachinon, Xanthon, Thioxanthon, Acridon sowie Derivate dieser Verbindungen, wie sie z.B. in der DE-A-20 03 122, der DE-A-21 22 036, der DE-A-28 11 755, der EP-A-33 721 und der US-A-3 759 087 beschrieben sind. Bevorzugt sind hierunter insbesondere Benzophenon und Benzophenon-Derivate, Anthrachinon und Anthrachinon-Derivate sowie die als Photoinitiator wirksamen Xanthon- und Thioxanthon- Verbindungen. Beispielhaft für die Verbindungen der allgemeinen Formel (I), die als Komponente a) der erfindungsgemäßen Photopolymerisationsinitiator-Kombination in Betracht kommen, seien genannt: Benzophenon, substituierte Benzophenone, wie Dimethylbenzophenon, Diethylbenzophenon, Dipropylbenzophenon, aminogruppenhaltige Benzophenone, 4,4'-Bis-dialkylamino-benzophenone, wie 4,4'-Bis-dimethylamino-benzophenon (Michlers Keton) und 4,4'-Bis-diethylamino-benzophenon, 4,4'-Bis-(N-$\beta$-hydroxyethyl-N-ethyl-amino)-benzophenon und ähnliche Benzophenon-Derivate, wie sie unter anderem in der EP-A-342 beschrieben sind, 4,4'-Bis-morpholinobenzophenon, Iminobenzophenone, wie z.B. Auramin O, Benzosuberon, Anthrachinon, 2-Methylanthrachinon, 2-Ethylanthrachinon, t-Butylanthrachinon, Xanthon, Thioxanthon, 2-Methylthioxanthon, 2-Chlorthioxanthon, 2-Isopropylthioxanthon und 2-t.-Butylthioxanthon sowie Mischungen aus 2-Methyl-und 4-Methyl-thioxanthon oder aus 2-Isopropyl-und 4-Isopropylthioxanthon. Unter den Verbindungen der allgemeinen Formel (I) besonders bevorzugt sind Benzophenon und seine Derivate, insbesondere die in 4,4'-Stellung mit Aminogruppen bis-substituierten Benzophenone, wie Michlers Keton, und die Thioxanthon-Derivate, wie insbesondere Chlorthioxanthon.

Als Komponente a) können in der erfindungsgemäß einzusetzenden Photoinitiator-Mischung eine oder mehrere der vorstehend genannten Verbindungen der allgemeinen Formel (I) enthalten sein.

Erfindungsgemäß enthält der Photoinitiator in den photopolymerisierbaren Gemischen in Kombination mit der vorstehend beschriebenen Komponente a) als Komponente b) mindestens eine s-Triazin-Verbindung der weiter oben angegebenen allgemeinen Formel (II). Als Komponente b) kommen dabei insbesondere die s-Triazin-Verbindungen in Betracht, die als solche als Photoinitiatoren bekannt und gebräuchlich sind. In der allgemeinen Formel (II) steht $R^6$ insbesondere für eine mono-, di- oder trihalogensubstituierte Methylgruppe, insbesondere für Monochlormethyl, Dichlormethyl, Trichlormethyl, Monobrommethyl, Dibrommethyl oder Tribrommethyl. Besonders vorteilhaft sind die s-Triazine der allgemeinen Formel (II), in denen $R^6$ eine Trichlormethyl- oder Tribrommethyl-Gruppierung darstellt. $R^7$ steht in der allgemeinen Formel (II) vorzugsweise für eine mono-, di- oder trihalogensubstituierte Methylgruppe, wie insbesondere Monochlormethyl, Monobrommethyl, Dichlormethyl, Dibrommethyl und ganz besonders bevorzugt Trichlormethyl oder Tribrommethyl, oder eine $-NR_2$-, -OR- oder -SR-Gruppe, worin R jeweils ein Wasserstoffatom, eine Alkylgruppe, vorzugsweise mit 1 bis 6 Kohlenstoffatomen, wie beispielsweise Methyl, Ethyl, Butyl oder Hexyl, oder eine Aryl-Gruppe, etwa die Phenylgruppe, darstellt. Besonders bevorzugte s-Triazin-Verbindungen der allgemeinen Formel (II) enthalten als Rest $R^7$ eine Trichlormethyl- oder Tribrommethyl-Gruppe. $R^8$ steht in der allgemeinen Formel (II) vorzugsweise für eine gegebenenfalls substituierte Alkylgruppe, eine gegebenenfalls substituierte Arylgruppe oder eine gegebenenfalls substituierte Alkenylgruppe. Geeignete Alkyl-Gruppen für den Rest $R^8$ sind insbesondere solche mit 1 bis etwa 10 C-Atomen, wie beispielsweise Methyl, Ethyl, Propyl oder Butyl, sowie halogensubstituierte Alkylgruppen, vorzugsweise chlor- oder bromsubstituierte Alkylgruppen mit 1 bis etwa 10 Kohlenstoffatomen, wie z.B. Trichlormethyl oder Tribrommethyl. Als Arylgruppen für den Rest $R^8$ kommen solche mit 1 bis 3 (kondensierten) Ringen, wie beispielsweise eine Phenylgruppe, eine Naphthylgruppe oder eine Anthrylgruppe, in Betracht, wobei diese Arylgruppen beispielsweise mit einem Alkylrest (vorzugsweise mit 1 bis 4 C-Atomen), einem Alkoxyrest (vorzugsweise mit 1 bis 4 C-Atomen), einem Halogenatom (vorzugsweise Chloratom oder Bromatom), einer Nitrogruppe oder einer Cyanogruppe substituiert sein können. Als Alkenylgruppen für den Rest $R^8$ kommen vorzugsweise solche in Betracht, die zwei oder mehrere miteinander in Konjugation stehende ethylenische Doppelbindungen enthalten und bei denen die ethylenische Doppelbindung bzw. die ethylenischen Doppelbindungen darüberhinaus in Konjugation mit einem aromatischen oder heteroaromatischen, gegebenenfalls substituierten, Ringsystem stehen. Bevorzugt für $R^8$ in der allgemeinen Formel (II) ist eine, gegebenenfalls substituierte, Arylgruppe der genannten Art sowie insbesondere eine 2'-Hydroxy-4'-methoxy-styryl-gruppe.

Verbindungen der allgemeinen Formel (II), wie sie als Komponente b) erfindungsgemäß in der

Photoinitiator-Kombination enthalten sein können, sind beispielsweise in der US-A-4 239 850, der US-A-3 954 475 und der DE-A-2 934 758 beschrieben. Beispielhaft für die gemäß der Erfindung einzusetzenden s-Triazin-Verbindungen der allgemeinen Formel (II) seien genannt: 2,4,6-Tris-(trichlormethyl)-s-triazin, 2-Methyl-4,6-bis-(trichlormethyl)-s-triazin, 2,4-Diethyl-6-dichlormethyl-s-triazin, 2-Phenyl-4,6-bis-(trichlormethyl)-s-triazin, 2-(p-Methoxyphenyl)-4,6-bis-(trichlormethyl)-s-triazin, 2-(p-Tolyl)-4,6-bis-(trichlormethyl)-s-triazin, 2-(o,p-Dichlorphenyl)-4,6-bis-(trichlormethyl)-s-triazin, 2-(p-Methoxystyryl)-4,6-bis-(trichlormethyl)-s-triazin, 2-Methyl-4,6-bis-(tribrommethyl)-s-triazin, 2,4,6-Tris-(dibrommethyl)-s-triazin, 2-(Naphthyl-1′)-4,6-bis-(trichlormethyl)-s-triazin, 2-(4′-Methoxy-naphthyl-1′)-4,6-bis-(trichlormethyl)-s-triazin und ähnliche. Bevorzugt sind hierbei die 4,6-Bis-(trichlormethyl)-s-triazine, die in 2-Stellung einen, gegebenenfalls substituierten, Arylrest tragen, wie unter anderem 2-(p-Methoxyphenyl)-4,6-bis-(trichlormethyl)-s-triazin und 2-(4′-Methoxy-naphthyl-1′)-4,6-bis-(trichlormethyl)-s-triazin, sowie 2-(2′-Hydroxy-3′-methoxystyryl)-4,6-bis-(trichlormethyl)-s-triazin, 2-(2′-Hydroxy-5′-methoxystyryl)-4,6-bis-(trichlormethyl)-s-triazin, 2-(2′-Hydroxy-6′-methoxystyryl)-4,6-bis-(trichlormethyl)-s-triazin, 2-(2′-Hydroxy-4′-ethoxystyryl)-4,6-bis-(trichlormethyl)-s-triazin, 2-(2′-Hydroxy-4′-phenoxystyryl)-4,6-bis-(trichlormethyl)-s-triazin und insbesondere 2-(2′-Hydroxy-4′-methoxy-styryl)-4,6-bis-(trichlormethyl)-s-triazin. Die letztgenannte Verbindung wirkt sich in den erfindungsgemäßen Aufzeichnungsschichten bzw. Flachdruckplatten besonders vorteilhaft auf deren Lagerstabilität aus.

In den erfindungsgemäßen photopolymerisierbaren Gemischen liegen die Komponenten a) und b) des Photoinitiators üblicherweise in einem solchen Gewichtsverhältnis zueinander vor, daß die Komponente b) den überwiegenden Anteil der Photoinitiator-Mischung ((a) + (b)) ausmacht. Im allgemeinen liegt in den photopolymerisierbaren Gemischen das Gewichtsverhältnis der Verbindungen der allgemeinen Formel (I) (Komponente a)) zu den Verbindungen der allgemeinen Formel (II) (Komponente b)) im Bereich von 10:90 bis 40:60 und insbesondere im Bereich von 15:85 bis 30:70. Die Verbindungen der allgemeinen Formel (I) (Komponente a)) sind dabei im allgemeinen in dem photopolymerisierbaren Gemisch in einer Menge von 0,1 bis 5 Gew.%, vorzugsweise in einer Menge von 0,8 bis 4 Gew.%, bezogen auf das photopolymerisierbare Gemisch, enthalten. Die Verbindungen der allgemeinen Formel (II), d.h. die Komponente b) des Photoinitiators, liegen in den erfindungsgemäßen photopolymerisierbaren Gemischen üblicherweise in einer Menge von 0,4 bis 10 Gew.%, vorzugsweise in einer Menge von 1,2 bis 8 Gew.%, bezogen auf das photopolymerisierbare Gemisch vor, wobei das Verhältnis der Komponenten (a) + (b) untereinander in dem vorstehend angegebenen Bereich liegt und die Summe der Komponenten a) und b), d.h. die Gesamtmenge an Photoinitiator, in dem photopolymerisierbaren Gemisch üblicherweise 0,5 bis 15 Gew.%, vorzugsweise 2 bis 12 Gew.%, bezogen auf das gesamte photopolymerisierbare Gemisch, beträgt.

Als ethylenisch ungesättigte, photopolymerisierbare Verbindungen für das erfindungsgemäße photopolymerisierbare Gemisch kommen grundsätzlich alle ethylenisch ungesättigten Verbindungen in Betracht, die einer photoinitiierten Polymerisations- oder Vernetzungsreaktion zugänglich sind. Hierzu gehören sowohl Monomere, als auch ethylenisch ungesättigte, photopolymerisierbare Oligomere und entsprechende ungesättigte Polymere. Die Monomeren haben dabei im allgemeinen ein Molekulargewicht unter 1.000. Das mittlere Molekulargewicht (Zahlenmittel) der ethylenisch ungesättigten, photopolymerisierbaren Oligomeren liegt vorzugsweise im Bereich von etwa 1.000 bis 10.000, insbesondere im Bereich von etwa 1.500 bis 6.000. Bevorzugt sind solche ethylenisch ungesättigten, photopolymerisierbaren Verbindungen, deren photopolymerisierbaren Doppelbindungen durch z.B. Aryl-, Carbonyl-, Amid-, Ester-, Carboxy- oder Nitril-Gruppen, Halogenatome, C-C-Doppel- oder C-C-Dreifachbindungen aktiviert sind. Die ethylenisch ungesättigten, photopolymerisierbaren Verbindungen können sowohl mono- als auch polyfunktionell sein, d.h. sie können eine oder mehrere photopolymerisierbare, ethylenische Doppelbindungen enthalten. Üblicherweise sind in den photopolymerisierbaren Gemischen, insbesondere wenn sie für die Herstellung von lichtempfindlichen Aufzeichnungselementen eingesetzt werden, bi- oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten. Die ethylenisch ungesättigten, photopolymerisierbaren Verbindungen, die allein oder in Mischung miteinander vorliegen, sind in der einschlägigen Fachliteratur hinreichend beschrieben. Ihre Auswahl, nach Art und Menge, richtet sich insbesondere nach dem Anwendungszweck der photopolymerisierbaren Gemische und ist dem Fachmann geläufig.

Zu den ethylenisch ungesättigten, photopolymerisierbaren Monomeren gehören beispielsweise die Vinylverbindungen, wie Vinylether, Vinylester, Styrol, Vinylchlorid, Vinylidenchlorid, Vinylketone, Vinylsulfone, N-Vinylpyrrolidon, N-Vinylcaprolactam, N-Vinylcarbazol, aber auch Allylester, wie Diallylphthalat. Besonders vorteilhaft sind die Acryloyl- und/oder Methacryloyl-Gruppen enthaltenden Monomeren. Hierzu gehören insbesondere die Ester der Acrylsäure und Methacrylsäure, wie z.B. die Di- und Tri-(meth)acrylate von zwei-oder mehrwertigen Alkoholen, wie etwa von Ethylenglykol, Diethylenglykol, Triethylenglykol oder

Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra-(meth)acrylat; die Monoacrylate und Monomethacrylate der genannten Diole oder Polyole, wie z.B. Ethylenglykol-, Di-, Tri- oder Tetraethylenglykolmono-(meth)acrylat, Propandiol-mono(meth)acrylat und Butandiol-mono(meth)acrylat; die (Meth)acrylate von Monoalkanolen, insbesondere von solchen mit 1 bis 20 C-Atomen; (Meth)Acrylamid, N-Methylol-(meth)-acrylamid, Methylen-bis-(meth)acrylamid, der Bisether des Ethylenglykols und N-Methylol-(meth)acrylamids; Urethanacrylate und -methacrylate mit 2 oder mehr Acryloyl- bzw. Methacryloyl-Gruppen, wie sie beispielsweise durch Umsetzung von organischen Di- oder Polyisocyanaten mit Monohydroxi-(meth)acrylaten, insbesondere Hydroxialkyl-(meth)acrylaten, hergestellt werden können; (Meth)acrylat-Monomere mit 2 oder mehr Acryloyl- und/oder Methacryloyl-Gruppen, wie sie durch Umsetzung von Acrylsäure und/oder Methacrylsäure mit Di- oder Polyglycidylverbindungen, insbesondere Di- oder Polyglycidylethern, erhalten werden können, wie z.B. das Umsetzungsprodukt aus 2 Mol Acrylsäure und/oder Methacrylsäure mit 1 Mol Bisphenol A-bis-glycidylether.

Zu den insbesondere bevorzugten photopolymerisierbaren ethylenisch ungesättigten Monomeren gehören unter anderem Trimethylolpropantriacrylat, Trimethylolpropantrimethacrylat, Pentaerythrittri- und -tetraacrylat, Pentaerythrittri- und -tetramethacrylat sowie monomere Urethan(meth)acrylate und monomere Epoxid(meth)acrylate der vorstehend genannten Art.

Als besonders vorteilhaft, insbesondere für die Herstellung von lichtempfindlichen Aufzeichnungselementen mit dünnen photopolymerisierbaren Aufzeichnungsschichten, wie sie beispielsweise bei der Herstellung von Resistmustern oder Flachdruckformen zur Anwendung gelangen, hat es sich erwiesen, wenn die photopolymerisierbaren Gemische als ethylenisch ungesättigte, photopolymerisierbare Verbindungen Oligomere, insbesondere filmbildende Oligomere, mit zwei oder vorzugsweise mehr als zwei Acryloyl-und/oder Methacryloyl-Gruppen enthalten. Hierbei kann es sich beispielsweise um Polyester(meth)acrylate, Acryloyl- und/oder Methacryloyl-Gruppen enthaltende, oligomere Urethanharze oder Acryloyl- und/oder Methacryloyl-Gruppen enthaltende, oligomere Harze auf Basis von Di- oder Polyepoxiden handeln, wie sie als solche bekannt und in der Literatur beschrieben sind. Von besonderem Interesse sind, insbesondere für den Einsatz der photopolymerisierbaren Gemische in lichtempfindlichen Aufzeichnungselementen, hierbei solche Oligomeren der in Rede stehenden Art, die neben den Acryloyl-und/oder Methacryloyl-Gruppen zusätzlich noch freie Carboxylgruppen im Molekül enthalten, so daß die Oligomeren in wäßrig-alkalischen Medien löslich oder dispergierbar sind. Der Anteil der freien Carboxyl-Gruppen in diesen photopolymerisierbaren Oligomeren liegt dabei vorteilhafterweise so hoch, daß die Oligomeren eine Säurezahl im Bereich von 50 bis 150 mg KOH/g aufweisen. Ethylenisch ungesättigte, photopolymerisierbare Oligomere, wie sie sich für den Einsatz in den erfindungsgemäßen photopolymerisierbaren Gemischen eignen, sind z.B. in der DE-A-24 42 527, der DE-C-25 57 408 oder auch der DE-A-29 17 483 beschrieben. Oligomere Polyester(meth)-acrylate können beispielsweise hergestellt werden durch Umsetzung von hydroxylgruppenhaltigen Polyestern mit Acryl- und/oder Methacrylsäure oder durch kettenverlängernde Umsetzung von (Meth)acryloyl-Gruppen enthaltenden Diolen mit Polycarbonsäuren, insbesondere Tri- oder Tetracarbonsäuren und bevorzugt deren cyclischen Anhydriden. Bei den (Meth)acryloyl-Gruppen enthaltenden Diolen kann es sich dabei beispielsweise um Reaktionsprodukte von Dicarbonsäuren mit Glycidyl(meth)acrylat oder um die Reaktionsprodukte von Acryl- und/oder Methacrylsäure mit Di- oder Polyepoxiden handeln.

Als sehr günstig haben sich als ethylenisch ungesättigte, photopolymerisierbare Verbindungen für die erfindungsgemäßen photopolymerisierbaren Gemische oligomere, freie Carboxylgruppen und mindestens zwei Acryloyl-und/oder Methacryloyl-Gruppen enthaltende Urethanharze erwiesen. Solche oligomeren Urethanharze, die vorzugsweise mehr als zwei (Meth)acryloyl-Gruppen pro Molekül enthalten, können beispielsweise hergestellt werden, indem man Acryloyl- und/oder Methacryloyl-Gruppen enthaltende Diole und/oder Polyole so mit Di-und/oder Polyisocyanaten, gegebenenfalls in Gegenwart von weiteren Diolen, unter Kettenverlängerung und Bildung eines oligomeren Urethanharzes umsetzt, daß nur ein Teil der Hydroxylgruppen der Diole und/oder Polyole in Urethangruppen überführt wird, worauf die restlichen Hydroxylgruppen der so erhaltenen Urethanharze ganz oder teilweise mit mehrwertigen Carbonsäuren oder deren Derivaten, insbesondere cyclischen Dicarbonsäureanhydriden, unter Bildung von sauren Teilestern der mehrfunktionellen Carbonsäuren verestert werden. Die (Meth)acryloyl-Gruppen enthaltenden Diole oder Polyole für die Umsetzung mit den Di- und/oder Polyisocyanaten können beispielsweise erhalten werden durch Umsetzung von Di- oder Polyepoxiden mit Acryl- und/oder Methacrylsäure in einer solchen Menge, daß vorzugsweise etwa 50 bis 100 % der Glycidylgruppen in $\beta$-Hydroxy(meth)acrylsäureester-Gruppen überführt werden. Als Beispiele für geeignete Di- und Polyepoxid-Verbindungen sind hier insbesondere die Di- und Polyglycidylether zwei- oder mehrwertiger Alkohole und insbesondere zwei- oder mehrwertiger Phenole, wie insbesondere der Diglycidylether aus Epichlorhydrin und Bisphenol A zu nennen. Die Di- und

Polyepoxide können vor oder während der Umsetzung mit der Acryl- und/oder Methacrylsäure auch noch durch Umsetzung mit aliphatischen oder aromatischen Dicarbonsäuren, wie beispielsweise Adipinsäure oder Phthalsäure, kettenverlängert werden. Zu den Di- und Polyisocyanaten, die für die weitere Umsetzung der so erhaltenen Polyhydroxy(meth)acrylate geeignet sind, gehören insbesondere aliphatische, cycloaliphatische und aromatische Diisocyanate, wie z.B. Hexamethylendiisocyanat, Cyclohexandiisocyanat, Toluylendiisocyanat, Isophorondiisocyanat und andere. Die Umsetzung mit den Isocyanaten erfolgt dabei unter Kettenverlängerung und Ausbildung eines Urethan-Oligomeren, welches noch restliche Hydroxylgruppen enthält. Anschließend werden die noch in dem Oligomeren verbliebenen freien Hydroxylgruppen mit mehrwertigen Carbonsäuren oder deren Derivaten, insbesondere aliphatischen oder aromatischen cyclischen Dicarbonsäureanhydriden, beispielsweise Phthalsäureanhydrid, unter Ausbildung der entsprechenden sauren Carbonsäurehalbester umgesetzt. Zur Herstellung dieser Carboxylgruppen und Acryloyl- und/oder Methacryloyl-Gruppen enthaltenden oligomeren Urethanharze werden die Di-oder Polyepoxide mit der (Meth)acrylsäure vorzugsweise im Äquivalentverhältnis Glycidylrest:Carbonsäurerest von 1:0,5-1 umgesetzt; die aus dieser Umsetzung resultierenden Di- oder Polyhydroxy(meth)acrylate werden anschließend mit den Di- und/oder Polyisocyanaten vorzugsweise im Äquivalenzverhältnis OH:NCO im Bereich von 1:0,2 bis 1:0,8 urethanisiert. Die restlichen Hydroxylgruppen der resultierenden Urethanoligomeren werden anschließend ganz oder teilweise mit den mehrfunktionellen Carbonsäuren bzw. deren Derivaten unter Bildung der sauren Teilester dieser Carbonsäuren in dem Maße, wie es zur Einstellung der gewünschten Säurezahl des Oligomeren erforderlich ist, umgesetzt.

Vorteilhaft sind auch solche photopolymerisierbaren, ethylenisch ungesättigten Oligomeren, wie sie erhalten werden, wenn man beispielsweise von einem oligomeren, mehrere Glycidylgruppen tragenden Harz einen Teil der Glycidylgruppen mit Acrylsäure und/oder Methacrylsäure und darauf den anderen Teil der Glycidylgruppen mit mehrfachen Carbonsäuren, insbesondere Dicarbonsäuren, wie z.B. Phthalsäure, Terephthalsäure oder Adipinsäure, unter Bildung von sauren Teilestern dieser mehrfachen Carbonsäure umsetzt. Ebenso vorteilhafte Oligomere erhält man, wenn man in ein oligomeres, mehrere freie Carboxylgruppen tragendes Harz die Acryloyl- und/oder Methacryloyl-Gruppen einführt, indem man einen Teil der freien Carboxylgruppen dieses Harzes mit Epoxidgruppen tragenden Acrylaten und/oder Methacrylaten, wie z.B. Glycidyl(meth)acrylat, umsetzt.

Weitere ethylenisch ungesättigte, photopolymerisierbare Oligomere, deren Einsatz in den erfindungsgemäßen photopolymerisierbaren Gemischen und damit hergestellten lichtempfindlichen Aufzeichnungselementen zu besonders günstigen Ergebnissen geführt hat, können beispielsweise hergestellt werden, indem man die Hydroxylgruppen einer Acryloyl- und/oder Methacryloyl-Gruppen enthaltenden Diol- oder Polyol-Verbindung derart mit mehrfachen Carbonsäuren oder insbesondere cyclischen Carbonsäureanhydriden umsetzt, daß sich die sauren Teilester der mehrfachen Carbonsäuren bilden, und anschließend einen Teil der freien Carboxylgruppen des so erhaltenen Reaktionsproduktes unter Kettenverlängerung sowie gegebenenfalls Verzweigung mit Di- und/oder Polyepoxiden umsetzt. Die Acryloyl-und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di-oder Polyglycidylether bzw. Di- oder Polyglycidylester, mit Acrylsäure und/oder Methacrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)-acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bis-glycidylether mit Acryl- und/oder Methacrylsäure bzw. mit einem Gemisch aus etwa 30 bis 70 Mol.% einer Dicarbonsäure, beispielsweise Adipinsäure, und etwa 30 bis 70 Mol.% Acryl- und/oder Methacrylsäure im Äquivalentverhältnis Glycidyl-Gruppen:Gesamt-COOH von etwa 1:1, Umsetzung der Hydroxyl-Gruppen des so erhaltenen Reaktionsprodukts mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von etwa 1:1 unter Bildung der sauren Teilester der mehrfachen Carbonsäuren und schließlich Umsetzung eines Teils der freien Carboxyl-Gruppen des so erhaltenen Reaktionsprodukts mit einem Di-und/oder Polyglycidylether, beispielsweise Bisphenol A-bis-glycidylether oder Pentaerythrittriglycidylether, im Äquivalentverhältnis COOH-Gruppen:Glycidyl-Gruppen von >1:1, vorzugsweise im Bereich von 1,15:1 bis 5:1.

Als ethylenisch ungesättigte, photopolymerisierbare oder photovernetzbare Verbindungen kommen erfindungsgemäß auch, wie bereits erwähnt, ungesättigte polymere Verbindungen in Betracht. Hierzu gehören beispielsweise ungesättigte Polyester, wie sie erhalten werden können aus $\alpha,\beta$-ungesättigten Dicarbonsäuren, gegebenenfalls im Gemisch mit gesättigten aliphatischen bzw. aromatischen Dicarbonsäuren, durch Umsetzung mit Alkandiolen oder oxalkyliertem Bisphenol A; ungesättigte Aminoplastharze, wie sie beispielsweise durch Umsetzung von gegebenenfalls veretherten Aminoplasten, wie Melamin/Formaldehyd- oder Harnstoff/Formaldehyd-Kondensationsprodukten, mit Hydroxyalkyl(meth)-acrylaten erhalten werden können; vinylgruppenhaltige Polyurethane, beispielsweise der in der US-A-3 658 531, der DE-A-23 00 371 oder der in der EP-A-72 918 beschriebenen Art, ferner auch modifizierte Polyvinylalkohole mit photopolymerisierbaren, olefinisch ungesättigten Seitengruppen, beispielsweise vinylgruppenhaltige Polyvinylalkohole oder acryloierte und/oder methacryloierte Polyvinylalkohole, wie sie unter anderem in der DE-A-15 22 359, der GB-A-834 337, der EP-A-129 901 oder der EP-A-129902 beschrieben sind.

Werden die erfindungsgemäßen photopolymerisierbaren Gemische für die Herstellung von wäßrig-entwickelbaren lichtempfindlichen Aufzeichnungselementen mit hoher Photoempfindlichkeit eingesetzt, haben sich als ethylenisch ungesättigte, photopolymerisierbare Verbindungen insbesondere auch freie Carboxylgruppen und Acryloyl- und/oder Methacryloyl-Gruppen enthaltende Vinylpolymerisate als besonders vorteilhaft erwiesen. Solche photopolymerisierbaren bzw. photovernetzbaren Polymeren sind unter anderem in der US-A-3 796 578 beschrieben. Hierzu gehören die in wäßrig-alkalischen Entwicklerlösungen löslichen oder zumindest dispergierbaren Copolymerisate von (Meth)acrylsäure und mindestens einem Comonomeren aus der Gruppe der Alkyl(meth)acrylate und monovinylaromatischen Monomeren sowie gegebenenfalls weiteren Comonomeren, z.B. (Meth)acrylnitril, Vinyl-estern oder Vinylethern, wobei ein Teil der freien Carboxylgruppen der einpolymerisierten (Meth)acrylsäure-Comonomereinheiten mit geeigneten (Meth)-acryloyl-Gruppen enthaltenden Verbindungen unter Einführung der (Meth)acryloyl-Gruppen in das Copolymerisat umgesetzt worden sind. Als (Meth)acryloyl-Gruppen enthaltende Verbindung für die Einführung der (Meth)acryloyl-Gruppen enthaltenden Reste in das Copolymerisat kommen insbesondere die (Meth)-acrylsäureglycidylester in Betracht. Diese vorteilhaften ethylenisch ungesättigten, photopolymerisierbaren bzw. photovernetzbaren Polymerisate haben üblicherweise ein Molekulargewicht (Gewichtsmittel) größer etwa 10.000, vorzugsweise im Bereich von etwa 15.000 bis etwa 500.000 und insbesondere von etwa 20.000 bis 250.000; die Säurezahl dieser Copolymerisate liegt im allgemeinen im Bereich von 40 bis 80 mg KOH/g, insbesondere im Bereich von etwa 50 bis 70 mg KOH/g. Als Alkyl(meth)acrylate für die Herstellung dieser Copolymerisate kommen insbesondere Alkylacrylate und Alkylmethacrylate mit 1 bis 8 C-Atomen im Alkylrest in Betracht. Beispiele für die monovinylaromatischen Comonomeren sind insbesondere Styrol, die kernsubstituierten Styrole und $\alpha$-Methylstyrol. Als Beispiele für die Basiscopolymerisate, deren freie Carboxylgruppen zur Einführung der (Meth)acryloyl-Gruppen mit Glycidylacrylat und/oder Glycidylmethacrylat teilweise umgesetzt werden, seien die (Meth)acrylsäure/Alkyl(meth)acrylat-Copolymerisate, die (Meth)-acrylsäure/Styrol-Copolymerisate und die (Meth)acrylsäure/Alkyl(meth)acrylat/Styrol-Copolymerisate genannt, die etwa 10 bis 40 Mol.% Acrylsäure und/oder Methacrylsäure einpolymerisiert enthalten. Typische Vertreter dieser Basis-Copolymerisate sind beispielsweise Copolymerisate aus 10 bis 30 Mol% (Meth)-acrylsäure und 70 bis 90 Mol% Methyl(meth)acrylat bzw. aus 10 bis 25 Mol% (Meth)acrylsäure, 25 bis 60 Mol% Methyl(meth)acrylat und 30 bis 50 Mol% Styrol. Zur Herstellung der erfindungsgemäß einzusetzenden ethylenisch ungesättigten, photopolymerisierbaren bzw. photovernetzbaren Polymeren werden diese (Meth)acrylsäure-Basiscopolymerisate mit einer Menge an Glycidylacrylat und/oder Glycidyl(meth)acrylat umgesetzt, die etwa 0,1 bis 0,7, insbesondere etwa 0,3 bis 0,6 Äquivalenten, bezogen auf die freien Carboxylgruppen in dem Basis-Copolymerisat, entspricht.

Neben den Photoinitiatoren und den ethylenisch ungesättigten, photopolymerisierbaren Verbindungen können die erfindungsgemäßen photopolymerisierbaren Gemische weitere Zusatz- und/oder Hilfsstoffe, insbesondere zur Verbesserung bzw. Modifizierung der anwendungs- und/oder verarbeitungstechnischen Eigenschaften, enthalten. Zu derartigen Zusatz- und/oder Hilfsstoffen gehören u.a. thermische Polymerisationsinhibitoren, Farbstoffe und/oder Pigmente, Füllstoffe, filmbildende nicht-photopolymerisierbare und nicht-photovernetzbare Polymere, Weichmacher, Verlaufshilfsmittel, Mattierungs- oder Gleitmittel, Verstärkungsmittel, UV-Stabilisatoren, photochrome Systeme und Sensibilisatoren. Diese Zusätze sind in den photopolymerisierbaren Gemischen - sofern sie vorhanden sind - in wirksamen Mengen enthalten, wie sie für diese Stoffe üblich und gebräuchlich und dem Fachmann geläufig sind. Sind in den photopolymerisierbaren Gemischen neben den ethylenisch ungesättigten, photopolymerisierbaren Verbindungen filmbildende, nicht-photopolymerisierbare und nicht-photovernetzbare polymere Bindemittel enthalten, wie z.B. Polyamide, Vinylalkohol-Polymere, teilverseifte Polyvinylacetate, Polyurethane, (Meth)acrylat(co)polymerisate, Styrol(co)polymerisate und dgl., so werden - wenn die photopolymerisierbaren Gemische für die Herstellung von lichtempfindlichen Aufzeichnungselementen eingesetzt werden sollen - diese filmbildenden polymeren Bindemittel so gewählt, daß sie mit den ethylenisch ungesättigten, photopolymerisierbaren Verbindungen verträglich sind. Für lichtempfindliche Aufzeichnungselemente, insbesondere Flachdruckplatten, werden vorzugsweise solche photopolymerisierbaren Gemische gewählt, die mit wäßrigen, insbesondere wäßrig-alkalischen, Lösungen entwickelbar sind. Sofern die photopolymerisierbaren Gemische filmbildende polymere Bindemittel enthalten, werden die filmbildenden polymeren Bindemittel in diesen Fällen daher vorzugsweise so ausgewählt, daß sie in den wäßrigen, insbesondere wäßrig-alkalischen, Entwicklerlösungen löslich oder zumindest dispergierbar sind. Hierzu gehören die für diese Anwendungszwecke an sich bekannten und gebräuchlichen Styrol/ Maleinsäureanhydrid-Copolymerisate, Styrol/Maleinsäure(halb)ester-Copolymerisate, Styrol/Maleinsäureanhydrid/(Meth)acrylsäure-Copolymerisate, (Meth)acrylsäureester/-(Meth)acrylsäure-Copolymerisate, Styrol/(Meth)acrylsäureester/(Meth)acrylsäure-Copolymerisate, Copolymerisate der vorstehend genannten Art, die darüberhinaus noch bis zu etwa 2 Gew.%, bezogen auf das Copolymerisat, an (Meth)acrylsäureanhydrid als Comonomer einpolymerisiert enthalten, wie sie z.B. in der EP-A-152 889 beschrieben sind, Dicyclopentadien/Maleinsäureanhydrid-Copolymerisate, wie sie z.B. in der EP-A-140 353 beschrieben sind, Copolymerisate aus 10 bis 50 Gew.% mindestens eines N-Vinyllactams, 5 bis 30 Gew.% Acrylsäure und/oder (Meth)Acrylsäure sowie 30 bis 80 Gew.% Styrol und/oder Alkyl(meth)-acrylaten, Copolymerisate aus 10 bis 50 Gew.% mindestens eines Hydroxyalkyl(meth)acrylats, 5 bis 30 Gew.% Acrylsäure und/oder Methacrylsäure und 30 bis 80 Gew.% mindestens eines Alkyl(meth)acrylats.

Geeignete thermische Polymerisationsinhibitoren, die in den photopolymerisierbaren Gemischen enthalten sein können, sind z.B. Hydrochinon, Hydrochinon-Derivate, 2,6-Di-t.-butyl-p-kresol, Nitrophenole, N-Nitrosodiphenylamin oder die Salze des N-Nitrosocyclohexylhydroxylamins. Beispiele für Farbstoff und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhoadmin 6G (C.I. 45 160) u.a. Photochrome Systeme, die bei Belichtung mit aktinischem Licht reversibel oder irreversibel ihre Farbe ändern, ohne hierbei den Photopolymerisationsprozeß zu stören, sind z.B. Leukofarbstoffe zusammen mit geeigneten Aktivatoren oder Photooxidantien. Die photopolymerisierbaren Gemische können bei ihrem Einsatz in lichtempfindlichen Aufzeichnungselementen auch sensitometrische Regler enthalten, wie z.B. 9-Nitroanthracen, 10,10′-Bisanthron, Phenacinium-, Phenoxacinium-, Acridinium- oder Phenothiacinium-Farbstoffe, insbesondere in Kombination mit milden Reduktionsmitteln, oder 1,3-Dinitrobenzole.

Art und Menge dieser Zusätze richten sich nach dem für die erfindungsgemäßen photopolymerisierbaren Gemische vorgesehenen Verwendungszweck; ihre Auswahl ist dem Fachmann geläufig. Sind in den erfindungsgemäßen photopolymerisierbaren Gemischen beispielsweise filmbildende, nicht-photopolymerisierbare bzw. nicht-photovernetzbare polymere Bindemittel enthalten, so werden als ethylenisch ungesättigte, photopolymerisierbare Verbindung im allgemeinen photopolymerisierbare Monomere oder Mischungen aus einem überwiegenden Anteil an photopolymerisierbaren Monomeren und einem untergeordneten Anteil an photopolymerisierbaren, ethylenisch ungesättigten Oligomeren eingesetzt. Handelt es sich bei den in den photopolymerisierbaren Gemischen enthaltenen ethylenisch ungesättigten photopolymerisierbaren Verbindungen um photopolymerisierbare, insbesondere filmbildende Oligomere oder um photopolymerisierbare bzw. photovernetzbare Polymere so kann vielfach auf den Zusatz von weiteren filmbildenden, nicht-photopolymerisierbaren und nicht-photovernetzbaren polymeren Bindemitteln verzichtet werden. Überraschenderweise haben sich die photopolymerisierbaren Gemische als besonders vorteilhaft erwiesen, die als ethylenisch ungesättigte, photopolymerisierbare Verbindung im wesentlichen nur ethylenisch ungesättigte, photopolymerisierbare, vorzugsweise filmbildende Oligomere und/oder photopolymerisierbare bzw. photovernetzbare Polymere und keine oder nur eine untergeordnete Menge an photopolymerisierbaren Monomeren und die ferner kein oder nur eine untergeordnete Menge an einem zusätzlichen, filmbildenden, nicht-photopolymerisierbaren und nicht-photovernetzbaren polymeren Bindemittel enthalten. Die erfindungsgemäßen photopolymerisierbaren Gemische werden üblicherweise im wesentlichen aus 0,5 bis 15 Gew.% des Photopolymerisationsinitiators aus den Komponenten a) und b), 5 bis 99,5 Gew.% der ethylenisch ungesättigten, photopolymerisierbaren Verbindungen, 0 bis 90 Gew.% eines filmbildenden, nicht-photopolymerisierbaren und nicht-photovernetzbaren polymeren Bindemittels und 0 bis 25 Gew.% an weiteren Zusatz- und/oder Hilfsstoffen, wie thermischen Polymerisationsinhibitoren, Farbstoffen und/oder Pigmenten, photochromen Verbindungen, sensitometrischen Reglern, Weichmachern, Füllstoffen, und Verstärkungsmitteln gebildet, wobei sich die angegebenen Gewichtsprozente jeweils auf das gesamte photopolymerisierbare Gemisch beziehen.

Die erfindungsgemäßen photopolymerisierbaren Gemische sind sehr vielseitig anwendbar und eignen sich insbesondere für die Herstellung von dünnen lichthärtbaren Schichten, beispielsweise einer Schichtdikke im Bereich von 0,1 bis 50 µm. Sie können daher in an sich bekannter Weise zur Herstellung von lichthärtbaren Lacken, zu Schutz- oder Dekorationszwecken dienenden Überzügen auf beliebigen Substraten, wie z.B. Metallen, Holz, Kunststoffen, Glas, Papier oder Pappe, von Tränkmaterialien oder von lichthärtbaren Druckfarben dienen. Zur Härtung und Photopolymerisation kommen dabei die üblichen Lichtquellen für aktinisches Licht in Betracht, insbesondere solche, deren Emissionsmaxima zwischen 300

und 420 nm liegen.

In besonders vorteilhafter Weise eignen sich die erfindungsgemäßen photopolymerisierbaren Gemische für die Herstellung von lichtempfindlichen Aufzeichnungselementen mit dünnen, lichtempfindlichen, photopolymerisierbaren Aufzeichnungsschichten, wie sie in der Reproduktionstechnik neben der Anwendung als Photoresist insbesondere bei der Herstellung von Flachdruckformen üblich und gebräuchlich sind.

Die erfindungsgemäßen lichtempfindlichen Aufzeichnungselemente enthalten dabei eine auf einem dimensionsstabilen Träger aufgebrachte lichtempfindliche, photopolymerisierbare Aufzeichnungsschicht aus einem erfindungsgemäßen photopolymerisierbaren Gemisch. Die lichtempfindliche, photopolymerisierbare Aufzeichnungsschicht dieser lichtempfindlichen Aufzeichnungselemente besitzt dabei üblicherweise eine Schichtdicke im Bereich von etwa 0,1 bis 50 µm. Während für Photoresistfilme dickere Aufzeichnungsschichten in Betracht kommen, beispielsweise im Bereich von 5 bis 50 µm, liegt die Dicke der photopolymerisierbaren Aufzeichnungsschicht für Flachdruckplatten vorzugsweise im Bereich von 0,5 bis 8 µm, insbesondere im Bereich von 0,7 bis 3,5 µm.

Als Trägermaterialien für die photopolymerisierbaren Aufzeichnungsschichten kommen die für lichtempfindliche Aufzeichnungselemente an sich üblichen und bekannten dimensionsstabilen, starren oder flexiblen Schichtträger in Betracht, wobei die Art des Schichtträgers vom Verwendungszweck der lichtempfindlichen Aufzeichnungselemente abhängt. Geeignete dimensionsstabile Schichtträger sind insbesondere Kunststoff-Filme oder -Folien, z.B. aus Polyethylenterephthalat, sowie metallische Schichtträger, beispielsweise Stahl-, Aluminium- oder Kupfer-Bleche. Bei Photoresistmaterialien kann die photopolymerisierbare Aufzeichnungsschicht auch direkt auf das zu schützende sowie gegebenenfalls dauerhaft zu modifizierende Substrat aufgebracht werden, welches dann als Träger für die photopolymerisierbare Aufzeichnungsschicht dient. Als Substrate für Photoresistschichten kommen unter anderem Kupferbleche, kupferkaschierte Basismaterialien, metall- oder metalloxid-beschichtete Keramiksubstrate, Halbleiterelemente, und Silicium-Wafer in Betracht. Bei lichtempfindlichen Aufzeichnungselementen, die für die Herstellung von Flachdruckformen dienen, werden als dimensionsstabile Schichtträger bevorzugt Aluminiumbleche oder -folien eingesetzt, die zweckmäßigerweise nach üblichen Methoden mechanisch oder elektrochemisch oberflächlich aufgerauht, anschließend vorzugsweise anodisch oxidiert und danach gegebenenfalls noch nachbehandelt worden sind. Zwischen der lichtempfindlichen, photopolymerisierbaren Aufzeichnungsschicht und dem dimensionsstabilen Schichtträger können auch noch eine oder mehrere Zwischenschichten angeordnet sein, die beispielsweise der Haftungsverbesserung dienen. Bei den erfindungsgemäßen lichtempfindlichen Aufzeichnungselementen werden solche Zwischenschichten zwischen dimensionsstabilem Träger und photopolymerisierbarer Aufzeichnungsschicht im allgemeinen entfallen.

Die Zusammensetzung der photopolymerisierbaren Aufzeichnungsschicht der erfindungsgemäßen lichtempfindlichen Aufzeichnungselemente kann in weiten Grenzen variiert werden. In einer üblichen Ausführungsform wird diese photopolymerisierbare Aufzeichnungsschicht aus einem erfindungsgemäßen photopolymerisierbaren Gemisch gebildet, welches im wesentlichen aus 0,5 bis 15 Gew.%, vorzugsweise 2 bis 12 Gew.%, des Photopolymerisationsinitiators aus den Komponenten a) und b), 8 bis 65 Gew.% an ethylenisch ungesättigten, photopolymerisierbaren Monomeren oder einer Mischung aus einem überwiegenden Anteil an photopolymerisierbaren Monomeren und einem untergeordneten Anteil an ethylenisch ungesättigten, photopolymerisierbaren Oligomeren und/oder photopolymerisierbaren bzw. photovernetzbaren Polymeren, 30 bis 90 Gew.% eines filmbildenden, nicht-photopolymerisierbaren und nicht-photovernetzbaren polymeren Bindemittels sowie 0 bis 25 Gew.% an weiteren Zusatz- und/oder Hilfsstoffen der vorstehend genannten Art besteht.

Als besonders vorteilhaft, insbesondere für die Herstellung von Flachdruckformen, hat es sich erwiesen, wenn die photopolymerisierbare Aufzeichnungsschicht der lichtempfindlichen Aufzeichnungselemente im wesentlichen gebildet wird aus einem erfindungsgemäßen, homogenen photopolymerisierbaren Gemisch von 0,5 bis 15 Gew.%, vorzugsweise 2 bis 12 Gew.%, des Photoinitiators aus den Komponenten a) und b), 99,5 bis 70 Gew.%, insbesondere 97,5 bis 75 Gew.%, mindestens eines ethylenisch ungesättigten, photopolymerisierbaren, freie Carboxylgruppen enthaltenden Oligomeren mit mindestens 2, vorzugsweise mehr als 2, Acryloyl- und/oder Methacryloyl-Gruppen im Molekül, einer Säurezahl im Bereich von 50 bis 120 mg KOH/g und einem mittleren Molekulargewicht (Zahlenmittel) im Bereich von 1.000 bis 10.000, vorzugsweise 1.500 bis 6.000, 0 bis 10 Gew.% mindestens eines mit dem Oligomeren verträglichen, ethylenisch ungesättigten, photopolymerisierbaren Monomeren mit einem Molekulargewicht unter 1.000, 0 bis 10 Gew.% mindestens eines mit den übrigen Komponenten verträglichen Polymeren mit oder ohne photopolymerisierbaren bzw. photovernetzbaren Gruppen sowie 0 bis 10 Gew.%, vorzugsweise 0,5 bis 5 Gew.%, an weiteren Zusatz- und/oder Hilfsstoffen, wie insbesondere thermischen Polymerisationsinhibitoren, Farbstoffen, Pigmenten, photochromen Systemen, Füllstoffen, Verstärkungsmitteln und dgl. Die vorstehend angegebenen Gewichtsprozente beziehen sich dabei jeweils auf das gesamte photopolymerisierbare

Gemisch. Als ethylenisch ungesättigte, photopolymerisierbare Oligomere für diese bevorzugten photopolymerisierbaren Aufzeichnungsschichten kommen insbesondere die weiter vorne genannten ethylenisch ungesättigten, photopolymerisierbaren Oligomere in Betracht. Falls diese bevorzugten, photopolymerisierbaren Aufzeichnungsschichten neben den ethylenisch ungesättigten, photopolymerisierbaren Oligomeren auch noch photopolymerisierbare Monomere und/oder Polymere enthalten, liegt der Anteil dieser Verbindungen im allgemeinen bei jeweils mindestens 1 Gew.%, bezogen auf die photopolymerisierbare Aufzeichnungsschicht. Es hat sich jedoch herausgestellt, daß auf den Zusatz von photopolymerisierbaren Monomeren und/oder Polymeren in diesen bevorzugten photopolymerisierbaren Aufzeichnungsschichten gänzlich verzichtet werden kann, wobei dann der Anteil der ethylenisch ungesättigten, photopolymerisierbaren Oligomeren in diesen photopolymerisierbaren Aufzeichnungsschichten mindestens 75 Gew.%, vorzugsweise mindestens 85 Gew.%, bezogen auf das gesamte photopolymerisierbare Gemisch, beträgt. Die lichtempfindlichen Aufzeichnungselemente mit solchen photopolymerisierbaren Aufzeichnungsschichten besitzen eine hohe Photoempfindlichkeit, zeigen eine äußerst geringe Inhibierung der Photopolymerisation durch Sauerstoff und erlauben in einfacher und schneller Verarbeitung eine exakte und vorlagengetreue Bildreproduktion.

In einer anderen sehr vorteilhaften Ausführungsform enthält die photopolymerisierbare Aufzeichnungsschicht der erfindungsgemäßen lichtempfindlichen Aufzeichnungselemente als ethylenisch ungesättigte, photopolymerisierbare Verbindung eine Mischung aus mindestens einem photopolymerisierbaren Monomeren und mindestens einem photopolymerisierbaren bzw. photovernetzbaren Vinylpolymerisat mit einem mittleren Molekulargewicht (Gewichtsmittel) im Bereich von 15.000 bis 500.000, vorzugsweise von 20.000 bis 250.000, bei dem etwa 3 bis 30 %, vorzugsweise 5 bis 25 %, aller wiederkehrenden Einheiten seitenständig gebundene, (Meth)acryloyl-Gruppen enthaltende Reste tragen und das ferner eine solche Menge an freien Carboxylgruppen enthält, daß die Säurezahl des Polymerisats im Bereich von 40 bis 100 mg KOH/g, vorzugsweise im Bereich von etwa 50 bis 90 mg KOH/g, liegt. In dieser Mischung der ethylenisch ungesättigten, photopolymerisierbaren Verbindungen liegt dabei das Gewichtsverhältis von den photopolymerisierbaren Monomeren zu den photopolymerisierbaren bzw. photovernetzbaren Polymerisaten üblicherweise im Bereich von etwa 1:15 bis 1:1, d.h. die photopolymerisierbaren bzw. photovernetzbaren Polymerisate bilden hierin in aller Regel den überwiegenden Anteil. Als photopolymerisierbare bzw. photovernetzbare Polymere für diese bevorzugten photopolymerisierbaren Aufzeichnungsschichten haben sich dabei insbesondere die weiter oben angesprochenen Copolymerisate aus Acrylsäure und/oder Methacrylsäure, monovinylaromatischen Monomeren und/oder Alkyl(meth)acrylaten sowie gegebenenfalls weiteren Comonomeren, in denen ein Teil der freien Carbonsäuregruppen durch Umsetzung mit Glycidylacrylat und/oder Glycidylmethacrylat in seitenständige, (Meth)acryloyl-Gruppen enthaltende Reste überführt worden ist, als besonders vorteilhaft erwiesen. Als photopolymerisierbare Monomere für diese Mischungen kommen vorzugsweise ebenfalls die weiter oben angeführten Acryloyl- oder Methacryloyl-Gruppen enthaltenden Monomeren in Betracht, die mit den photopolymerisierbaren bzw. photovernetzbaren Polymerisaten der in Rede stehenden Art verträglich sind. Bei dieser bevorzugten Ausgestaltungsform der erfindungsgemäßen lichtempfindlichen Aufzeichnungselemente wird die photopolymerisierbare Aufzeichnungsschicht im wesentlichen gebildet aus einem erfindungsgemäßen, homogenen, photopolymerisierbaren Gemisch von 0,5 bis 15 Gew.%, vorzugsweise 2 bis 12 Gew.%, eines Photopolymerisationsinitiators aus den Komponenten a) und b), 75 bis 99,5 Gew.%, vorzugsweise 85 bis 97 Gew.%, der vorstehend genannten Mischung von photopolymerisierbaren Monomeren und photopolymerisierbaren bzw. photovernetzbaren Polymeren als ethylenisch ungesättigte, photopolymerisierbare Verbindung sowie 0 bis 10 Gew.%, vorzugsweise 0,5 bis 5 Gew.%, an Zusatz- und/oder Hilfsstoffen, wie thermischen Polymerisationsinhibitoren, Farbstoffen, Pigmenten, photochromen Systemen, Füllstoffen, und Verstärkungsmitteln, wobei die Prozentangaben jeweils auf das gesamte photopolymerisierbare Gemisch bezogen sind. Auch in diesem Fall zeichnen sich die lichtempfindlichen Aufzeichnungselemente der Erfindung durch ihre sehr guten Belichtungs- und Reproduktionseigenschaften aus, wobei auch bei diesen lichtempfindlichen Aufzeichnungselementen neben einer sehr hohen Photoempfindlichkeit nur eine äußerst geringe Inhibierung der Photopolymerisation durch Sauerstoff festzustellen ist, so daß ihre Belichtung ohne besondere Vorsichtsmaßnahmen durchgeführt werden kann. Die photopolymerisierbaren Aufzeichnungsschichten dieser lichtempfindlichen Aufzeichnungselemente sind darüber hinaus trocken, fest und nicht klebrig, wodurch ihre Handhabung wesentlich erleichtert wird.

Die Bestandteile der photopolymerisierbaren Aufzeichnungsschicht der erfindungsgemäßen lichtempfindlichen Aufzeichnungselemente werden darüber hinaus ganz allgemein so gewählt und aufeinander abgestimmt, daß die Aufzeichnungselemente nach der bildmäßigen Belichtung mit aktinischem Licht in den hierfür üblichen und gebräuchlichen Entwicklerlösungen, insbesondere wäßrig-alkalischen Entwicklerlösungen, entwickelbar sind. Auch wenn es grundsätzlich möglich ist, daß auf der dem Träger abgewandten Oberfläche der photopolymerisierbaren Aufzeichnungsschicht noch eine Deckschicht angebracht ist, die

vorzugsweise in der gleichen Entwicklerlösung löslich ist wie die photopolymerisierbare Aufzeichnungsschicht, so kann bei den erfindungsgemäßen lichtempfindlichen Aufzeichnungselementen wegen der hohen Lichtempfindlichkeit und Sauerstoffunempfindlichkeit der erfindungsgemäßen photopolymerisierbaren Gemische auf eine solche Deckschicht, wie sie sonst bei lichtempfindlichen Aufzeichnungselementen der in Rede stehenden Art üblich und gebräuchlich ist, verzichtet werden.

Die Herstellung der erfindungsgemäßen lichtempfindlichen Aufzeichnungselemente kann in an sich bekannter und üblicher Weise durch Herstellung einer homogenen Mischung der die photopolymerisierbare Aufzeichnungsschicht bildenden Komponenten und schichtförmiges Aufbringen dieser Mischung auf den - gegebenenfalls mit einer Zwischenschicht versehenen - dimensionsstabilen Träger erfolgen. Beispielsweise kann man hierzu die Komponenten der photopolymerisierbaren Aufzeichnungsschicht in einem geeigneten Lösungsmittel oder Lösungsmittelgemisch lösen und diese Lösung durch Gießen, Tauchen, Sprühen oder andere bekannte Auftragstechniken in der gewünschten Schichtstärke auf den Träger aufbringen. Anschließend wird das Lösungsmittel in üblicher Weise entfernt und die photopolymerisierbare Aufzeichnungsschicht getrocknet. Geeignete Lösungsmittel für das Mischen der Komponenten und Aufbringen der photopolymerisierbaren Aufzeichnungsschicht auf den Träger sind u.a. niedere Alkohole, Ketone oder Ester, wie z.B. Methanol, Aceton, Methylethylketon, und Ethylacetat, sowie Mischungen hiervon. Sofern für die lichtempfindlichen Aufzeichnungselemente noch eine Deckschicht vorgesehen ist, kann diese anschließend auf die photopolymerisierbare Aufzeichnungsschicht aufgebracht werden.

Die erfindungsgemäßen lichtempfindlichen Aufzeichnungselemente eignen sich beispielsweise für die Herstellung von Resistmustern, Schablonen, und Siebdruckformen nach den hierfür an sich bekannten und üblichen Verfahren und sind insbesondere geeignet für die Herstellung von Flachdruckformen. Hierzu wird die photopolymerisierbare Aufzeichnungsschicht bildmäßig mit aktinischem Licht belichtet, wobei sich hierfür die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenonimpulslampen, aber auch die bekannten UV-Laser eignen. Die von den Lichtquellen emittierte Wellenlänge ist vorzugsweise auf die Eigenabsorption des Photoinitiators abgestimmt und liegt im allgemeinen im Bereich von 300 bis 420 nm. Durch die bildmäßige Belichtung mit dem aktinischen Licht wird in den belichteten Bereichen der Aufzeichnungsschicht eine Photopolymerisation ausgelöst, die zu einer Vernetzung und damit zu einer Löslichkeitsdifferenzierung zwischen belichteten und unbelichteten Schichtbereichen führt. Nach der bildmäßigen Belichtung kann die Flachdruckform durch Auswaschen der unbelichteten, unvernetzten Bereiche der Aufzeichnungsschicht mit einer hierfür geeigneten Entwicklerlösung entwickelt werden. Das Entwickeln kann beispielsweise durch Waschen, Sprühen, Reiben, Bürsten etc. erfolgen. Für die Herstellung von Flachdruckformen werden solche lichtempfindlichen Aufzeichnungselemente bevorzugt, die mit wäßrig-alkalischen Entwicklerlösungen, im allgemeinen mit einem pH-Wert im Bereich von 8 bis 14, vorzugsweise im Bereich von etwa 9 bis 13, entwickelt werden können. Die so hergestellten Flachdruckformen können -falls gewünscht- in an sich üblicher Weise nachbehandelt werden. Die Nachbehandlung kann dabei neben dem Trocknen der Flachdruckform nach der Entwicklung eine vollflächige Nachbelichtung mit aktinischem Licht oder auch eine Wärmebehandlung umfassen. Ebenso können die wasserführenden Oberflächenbereiche der so hergestellten Flachdruckform zusätzlich hydrophiliert oder gummiert werden.

Die Erfindung wird durch die nachfolgenden Beispiele näher erläutert. Die in den Beispielen genannten Teile und Prozente beziehen sich, sofern nicht anders angegeben, auf das Gewicht. Volumenteile verhalten sich zu Teilen wie Liter zu Kilogramm.

Beispiele 1 bis 5

In einem Lösungsmittelgemisch aus gleichen Teilen Tetrahydrofuran und Essigsäureethylester wurden jeweils 10 %ige Lösungen einer Mischung aus 91 Teilen eines ethylenisch ungesättigten, photopolymerisierbaren Oligomeren, einem Teil Viktoria Reinblau B (C.I. 44 045), 2 Teilen der jeweiligen in der nachfolgenden Tabelle 1 angegebenen Verbindung (I) und 6 Teilen der jeweiligen in der nachfolgenden Tabelle 1 angegebenen Verbindung (II) hergestellt. Das ethylenisch ungesättigte, photopolymerisierbare Oligomere war hergestellt worden durch Umsetzung von 1 Mol Bisphenol A-bis-glycidylether mit 2 Mol Acrylsäure und weitere Umsetzung des erhaltenen Reaktionsproduktes mit 0,5 Mol Hexamethylendiisocyanat unter gleichzeitiger Kettenverlängerung sowie Umsetzung der freien Hydroxylgruppen des resultierenden Urethanacrylat-Harzes mit 0,6 Mol Phthalsäureanhydrid. Die homogenen Lösungen wurden mittels einer Rakelvorrichtung (Gießspalt 35 µm, Abzugsgeschwindigkeit 250 mm/min) auf elektrolytisch aufgerauhte und anodisch oxidierte Aluminiumträgerbleche, wie sie für Flachdruckplatten typisch sind, aufgetragen. Nach jeweils 10 minütiger Trocknung bei 80 °C resultierten photopolymerisierbare Schichten mit einer Trockenschichtdicke von 2,5 µm (ca. 2,7 g/$m^2$). Die so hergestellten Flachdruckplatten (ohne Sauerstoffsperrschicht)

verblieben zunächst für 6 Tage in einem verschlossenen Beutel. Danach wurden sie zur Ermittlung der erforderlichen Mindestbelichtungszeit durch einen FOGRA PMS-Teststreifen mit aktinischem Licht belichtet. Nach der Belichtung wurden die Platten mit einer 1 %igen wäßrigen Sodalösung (pH-Wert ca. 11) in 45 Sekunden entwickelt. Die Mindestbelichtungszeiten sowie die mit diesen Platten erzielte Auflösung sind ebenfalls in Tabelle 1 angeführt.

Die vorstehenden Versuche wurden wiederholt, diesmal wurde jedoch auf die freie Oberfläche der photopolymerisierbaren Schicht der Flachdruckplatten unmittelbar nach der Trocknung eine Sauerstoffsperrschicht aus einem Polyvinylalkohol (Verseifungsgrad ca. 98 %) in einer Schichtdicke von 5 $\mu$m (ca. 6 g/$m^2$) aufgebracht. Für diese Flachdruckplatten mit Sauerstoffsperrschicht wurde in gleicher Weise wie für die Platten ohne Sauerstoffsperrschicht die erforderliche Mindestbelichtungszeit und die erzielbare Auflösung durch bildmäßige Belichtung mit aktinischem Licht durch den FOGRA PMS-Teststreifen ermittelt. Die Ergebnisse sind ebenfalls in Tabelle 1 zusammengestellt.

Wie aus Tabelle 1 ersichtlich ist, sind mit den erfindungsgemäßen photopolymerisierbaren Gemischen nur kurze Belichtungszeiten erforderlich, wobei gleichzeitig eine gute Auflösung erzielt wird. Die Ergebnisse zeigen ferner, daß in den erfindungsgemäßen photopolymerisierbaren Aufzeichnungsmaterialien der inhibierende Einfluß von Sauerstoff auf die Photopolymerisation nur sehr gering ist, so daß es möglich ist, auf Sauerstoffsperrschichten zu verzichten.

Vergleichsversuch A

Es wurde wie in Beispiel 1 verfahren, diesmal jedoch auf den Zusatz der Verbindung (II) verzichtet. Die Ergebnisse sind ebenfalls in Tabelle 1 enthalten.

Vergleichsversuch B

Es wurde wie in Beispiel 1 verfahren, diesmal jedoch auf den Zusatz der Verbindung (I) verzichtet. Die Ergebnisse sind in Tabelle 1 wiedergegeben.

Vergleichsversuch C

Es wurde wie in Beispiel 1 verfahren, diesmal jedoch zur Herstellung der photopolymerisierbaren Mischung anstelle der Verbindung (II) 6 Teile Benzophenon eingesetzt. Wie sich aus den in Tabelle 1 angegebenen Werten ergibt, benötigt der Photoinitiator Michlers Keton/Benzophenon sehr lange Belichtungszeiten, wenn ohne eine Sauerstoffsperrschicht gearbeitet wird, verglichen mit der erfindungsgemäßen Mischung von Beispiel 1, bei der als Initiator eine Kombination aus Michlers Keton/s-Triazin eingesetzt wurde. Durch Verwendung einer Sperrschicht läßt sich zwar die Mindestbelichtungszeit für die photopolymerisierbaren Mischungen mit dem Initiatorsystem Michlers Keton/Benzophenon sehr stark herabsetzen, hierdurch wird aber das Auflösungsvermögen der lichtempfindlichen Aufzeichnungselemente stark vermindert, so daß feine Bildelemente nicht mehr exakt reproduziert werden können.

Tabelle 1

| Beispiel/ Vergleichsversuch | Verbindung (I) | Verbindung (II) | Mindestbelichtungszeit [s] ohne Sperrschicht | Mindestbelichtungszeit [s] mit Sperrschicht | noch reproduzierbare offene Spalte (µm) ohne Sperrschicht | noch reproduzierbare offene Spalte (µm) mit Sperrschicht |
|---|---|---|---|---|---|---|
| 1 | Michlers Keton | 2-(p-Methoxyphenyl)-4,6-bis-(trichlormethyl)-s-triazin | 8 | 7 | 12 | 15 |
| 2 | Thioxanthon | dito | 18 | 16 | 15 | 20 |
| 3 | 2-Chlorthioxanthon | dito | 13 | 11 | 15 | 20 |
| 4 | 4,4'-Bis-morpholinobenzophenon | dito | 14 | 14 | 15 | 20 |
| 5 | 4,4'-Bis-(β-hydroxyethylmethylamino)-benzophenon | dito | 9 | 8 | 12 | 15 |
| A | Michlers Keton | ohne | 120 | 75 | 20 | 40 |
| B | ohne | wie Bsp. 1 | 25 | 18 | 30 | > 40 |
| C | Michlers Keton | Benzophenon | 40 | 1 | 10 | 30 |

Beispiel 6

Es wurde eine Lösung aus 110 Teilen des Umsetzungsproduktes aus 1 Mol Butandioldiglycidylether und 2 Mol Acrylsäure, 141 Teilen eines Methylmethacrylat/Methacrylsäure-Copolymerisats (70:30), dessen

einpolymerisierte Methacrylsäureeinheiten zu 65 Mol% mit Glycidylmethacrylat unter Ausbildung von seitenständigen Methacrylat-Gruppen im Copolymerisat umgesetzt worden waren, 5,5 Teilen Michlers Keton, 16,6 Teilen 2-(4'-tert.-Butylstyryl)-4,6-bis-(trichlormethyl)-s-triazin und 2,5 Teilen eines blauen Farbstoffs in 2500 Vol.-Teilen Tetrahydrofuran hergestellt und auf ein offsettypisches Aluminiumblech so aufgegossen, daß nach dem Abdampfen des Lösungsmittels und Trocknen eine photopolymerisierbare Aufzeichnungsschicht mit einem Schüttgewicht von ca. 2,5 $g/m^2$ resultiert. Die so erhaltene Flachdruckplatte wurde ohne Sauerstoffsperrschicht, wie in Beispiel 1 beschrieben, gelagert, bildmäßig belichtet und entwickelt. Die erzielte Auflösung war sehr gut. 6 µm breite Linien bzw. offene Spalten konnten problemlos reproduziert werden. Die erforderliche Mindestbelichtungszeit betrug 25 Sekunden. Es wurde eine Flachdruckform von einwandfreier Qualität erhalten.

Beispiel 7

Es wurde wie in Beispiel 6 gearbeitet, diesmal jedoch anstelle des in Beispiel 6 eingesetzten Copolymerisats 141 Teile eines Methylmethacrylat/Methacrylsäure-Copolymerisats (70:30) verwendet, dessen Carboxylgruppen zu 50 Mol% mit Glycidylacrylat unter Ausbildung von seitenständigen Acrylat-Gruppen im Copolymerisat umgesetzt worden waren. Ferner wurden diesmal als s-Triazin-Komponente für den Photoinitiator 6 Teile 2-(2'-Hydroxy-3'-methoxy-styryl)-4,6-bis-(trichlormethyl)-s-triazin eingesetzt. Es wurden vergleichbar gute Ergebnisse erhalten wie in Beispiel 6.

Beispiel 8

Beispiel 6 wurde wiederholt, diesmal jedoch der Anteil des Copolymerisats auf 155 Teile erhöht und der Anteil der s-Triazin-Verbindung auf 8,3 Teile erniedrigt. Ferner wurde diesmal als s-Triazin-Verbindung 2-(2'-Hydroxy-3'-methoxy-styryl)-4,6-bis-(trichlormethyl)-s-triazin eingesetzt und die lichtempfindliche Aufzeichnungsschicht nach dem Trocknen mit einer etwa 2 µm starken Polyvinylalkohol-Deckschicht versehen. Die Mindestbelichtungszeit betrug diesmal nur 17 Sekunden; es konnten trotz der Verwendung einer Deckschicht 12 µm-Linien und -Spalte einwandfrei reproduziert werden.

Beispiele 9 bis 13

Beispiel 6 wurde unter Variation der Komponenten für den Photoinitiator wiederholt. Die in den einzelnen Beispielen eingesetzten Photoinitiator-Komponentensind der Tabelle 2 zu entnehmen. Die erzielten Ergebnisse (Mindestbelichtungszeit, Auflösungsvermögen) sind ebenfalls in Tabelle 2 enthalten. Wie hieraus zu ersehen ist, konnte in allen Fällen bei vergleichsweise kurzen Belichtungszeiten eine sehr gute Auflösung erzielt werden.

Tabelle 2

| Beispiel | Photoinitiator Komponente a | Komponente b* | Mindestbelichtungszeit [s] | noch reproduzierbare freistehende Linien bzw. offene Spalte [µm] |
|---|---|---|---|---|
| 9 | Michlers Keton | 2-(4'-tert.-Butoxystyryl)- | 20 | 15 |
| 10 | dito | 2-(4'-Allyl-oxy-styryl)- | 35 | 12 |
| 11 | dito | 2-(2'-Hydroxy--styryl)- | 30 | 8 |
| 12 | dito | 3-(3',4'-Methylendioxo-styryl)- | 20 | 6 |
| 13 | Benzosuberon | 2-(p-Methoxy-phenyl)- | 30 | 6 |

* bei Komponente b handelte es sich in allen Fällen um eine 4,6-Bis-(trichlormethyl)-s-triazin-Verbindung, wobei jeweils der Substituent in 2-Stellung, wie angegeben, geändert wurde.

Beispiel 14

In 900 Teilen Tetrahydrofuran wurden 55 Teile eines Styrol/Maleinsäurehalbester-Copolymerisats (Scripset® 540 der Fa. Monsanto), 40 Teile Trimethylolpropantriacrylat, 1 Teil Victoria Blau, 2 Teile 4,4'-Bis-(dimethylamino)-benzophenon und 3 Teile 2-(3'-Methoxy-4'-hydroxy-styryl)-4,6-bis-(trichlormethyl)-s-triazin gelöst. Mit dieser Lösung wurde ein elektrolytisch aufgerauhtes und anodisch oxidiertes Aluminiumträgerblech so beschichtet, daß nach Trocknung (5 min bei 75 ° C) eine Trockenschichtdicke der photopolymerisierbaren Schicht von 1,8 µm (ca. 2 g/m$^2$) resultierte. Die so hergestellte Flachdruckplatte wurde ohne Sauerstoffsperrschicht in einem handelsüblichen Offsetbelichter bildmäßig belichtet und anschließend mit einer wäßrig-alkalischen Lösung entwickelt. Die Mindestbelichtungszeit für diese Flachdruckplatte betrug 70 Sekunden; es konnten noch Linien und offene Spalte mit einer Breite von 8 µm problemlos und einwandfrei reproduziert werden.

Beispiel 15

Es wurde wie in Beispiel 6 beschrieben gearbeitet jedoch anstelle von 2-(4'-tert.-Butyl-styryl)-4,6-bis-(trichlormethyl)-s-triazin 2-(2'-Hydroxy-4'-methoxy-styryl)-4,6-bis-(trichlormethyl)-s-triazin eingesetzt. Die mit diesem Triazinderivat hergestellten Flachdruckplatten zeichnen sich durch hervorragende Lagerfähigkeit aus. Auch nach einjähriger Lagerung war keinerlei Auskristallisieren zu beobachten. Bei Weiterverarbeitung der Flachdruckplatten erhält man einwandfreie Flachdruckformen.

**Patentansprüche**
**Patentansprüche für folgende Vertragsstaaten : BE, CH, DE, FR, GB, IT, LI, NL, SE**

**1.** Photopolymerisierbares Gemisch, enthaltend mindestens eine ethylenisch ungesättigte, photopolymerisierbare oder photovernetzbare Verbindung sowie einen Photopolymerisationsinitiator, dadurch gekennzeichnet, daß der Photopolymerisationsinitiator eine Kombination umfaßt von

a) einer Verbindung der allgemeinen Formel (I)

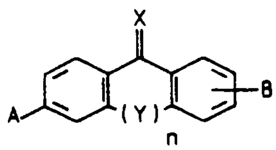

(I),

worin bedeuten

A ein Wasserstoffatom, eine gegebenenfalls substituierte Alkylgruppe, eine $-NR^1R^2$-Gruppe (mit $R^1$, $R^2$ gleich oder verschieden und unabhängig voneinander einem Wasserstoffatom oder einem, gegebenenfalls substituierten, aliphatischen, aromatischen oder gemischt aliphatisch-aromatischen Rest) oder eine $-OR^3$-Gruppe (mit $R^3$ gleich einem Wasserstoffatom oder einem, gegebenenfalls substituierten, aliphatischen, aromatischen oder gemischt aliphatisch-aromatischen Rest),

B einen Rest der unter A genannten Art (wobei die Reste A und B untereinander gleich oder verschieden sein können), ein Halogenatom oder die -C≡N-Gruppe,

X ein Sauerstoffatom, ein Schwefelatom oder eine $=NR^4$-Gruppe (mit $R^4$ gleich einem Wasserstoffatom oder einem aliphatischen, aromatischen oder gemischt aliphatisch-aromatischen Rest),

Y eine direkte Bindung, eine $-CH_2-$, $-CH_2-CH_2-$, -O-, -S-, -C(O)- oder $-NR^5$-Gruppierung (mit $R^5$ gleich einem Wasserstoffatom oder einem aliphatischen oder aromatischen Rest) und

n 0 oder 1,

und

b) mindestens einer Verbindung der allgemeinen Formel (II)

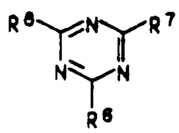

(II),

worin bedeuten

$R^6$, $R^7$, $R^8$ gleich oder verschieden, eine gegebenenfalls substituierte Alkylgruppe, eine gegebenenfalls substituierte Arylgruppe oder eine gegebenenfalls substituierte Aralkylgruppe, wobei mindestens einer der Reste $R^6$ bis $R^8$ eine mono-, di- oder trihalogensubstituierte Methylgruppe darstellt und einer der Reste $R^6$, $R^7$ oder $R^8$ auch eine gegebenenfalls substituierte Alkenylgruppe, eine $-NR_2$-, -OR- oder -SR-Gruppe sein kann, wobei R jeweils für ein Wasserstoffatom, eine Alkyl- oder eine Arylgruppe steht.

**2.** Photopolymerisierbares Gemisch gemäß Anspruch 1, dadurch gekennzeichnet, daß in der allgemeinen Formel (I) X ein Sauerstoffatom darstellt.

**3.** Photopolymerisierbares Gemisch gemäß einem der Ansprüche 1 oder 2, dadurch gekennzeichnet, daß in der allgemeinen Formel (I) n gleich 0 ist und die Reste A und B, gleich oder verschieden, jeweils ein Wasserstoffatom oder eine $-NR^1R^2$-Gruppe darstellen.

**4.** Photopolymerisierbares Gemisch gemäß Anspruch 3, dadurch gekennzeichnet, daß in der allgemeinen Formel (I) n gleich 0 ist und jeder der Reste A und B eine $-NR^1R^2$-Gruppe darstellt, worin $R^1$ und $R^2$ gleich oder verschieden sein können und eine Alkylgruppe mit 1 bis 4 C-Atomen, eine Hydroxyalkylgruppe mit 2 bis 3 C-Atomen oder zusammen unter Ausbildung eines heterocyclischen Ringes eine Alkylen-Gruppe mit 4 oder 5 C-Atomen darstellen.

**5.** Photopolymerisierbares Gemisch gemäß einem der Ansprüche 1 oder 2, dadurch gekennzeichnet, daß in der allgemeinen Formel (I) n gleich 1 ist und Y ein Sauerstoffatom, ein Schwefelatom oder die

Carbonylgruppe darstellt.

6. Photopolymerisierbares Gemisch gemäß Anspruch 5, dadurch gekennzeichnet, daß in der allgemeinen Formel (I) n gleich 1 ist, Y ein Schwefelatom oder die Carbonylgruppe darstellt, A für ein Wasserstoffatom steht und B einen Alkylrest mit 1 bis 6 C-Atomen oder ein Halogenatom bedeutet.

7. Photopolymerisierbares Gemisch gemäß einem der Ansprüche 1 bis 6, dadurch gekennzeichnet, daß in der allgemeinen Formel (II) $R^6$ eine mono-, di- oder trihalogensubstituierte Methylgruppe ist.

8. Photopolymerisierbares Gemisch gemäß einem der Ansprüche 1 bis 6, dadurch gekennzeichnet, daß in der allgemeinen Formel (II) $R^6$ Trichlormethyl oder Tribrommethyl ist.

9. Photopolymerisierbares Gemisch gemäß Anspruch 7 oder 8, dadurch gekennzeichnet, daß in der allgemeinen Formel (II) $R^7$ ebenfalls eine mono-, di- oder trihalogensubstituierte Methylgruppe ist.

10. Photopolymerisierbares Gemisch gemäß Anspruch 7 oder 8, dadurch gekennzeichnet, daß in der allgemeinen Formel (II) $R^7$ Trichlormethyl oder Tribrommethyl ist.

11. Photopolymerisierbares Gemisch gemäß einem der Ansprüche 1 bis 10, dadurch gekennzeichnet, daß in der allgemeinen Formel (II) $R^8$ eine Styrylgruppe der allgemeinen Formel

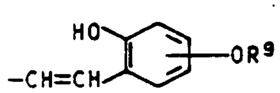

ist, worin $R^9$ für Wasserstoff, eine Alkylgruppe oder eine Arylgruppe steht.

12. Photopolymerisierbares Gemisch nach Anspruch 11, dadurch gekennzeichnet, daß die Verbindung der allgemeinen Formel (II) 2-(2′-Hydroxy-4′-methoxy-styryl)-4,6-bis-(trichlormethyl)-s-triazin ist.

13. Photopolymerisierbares Gemisch gemäß einem der Ansprüche 7 bis 10, dadurch gekennzeichnet, daß in der allgemeinen Formel (II) $R^8$ für einen gegebenenfalls substituierten Arylrest steht.

14. Photopolymerisierbares Gemisch nach einem der Ansprüche 1 bis 4 und 7 bis 13, dadurch gekennzeichnet, daß es sich bei der Verbindung der allgemeinen Formel (I) um Benzophenon oder ein Benzophenon-Derivat handelt.

15. Photopolymerisierbares Gemisch nach einem der Ansprüche 1 bis 4 und 7 bis 13, dadurch gekennzeichnet, daß es sich bei der Verbindung der allgemeinen Formel (I) um Michlers Keton handelt.

16. Photopolymerisierbares Gemisch gemäß einem der Ansprüche 1 bis 2 und 5 bis 13, dadurch gekennzeichnet, daß es sich bei der Verbindung der allgemeinen Formel (I) um Thioxanthon oder ein Thioxanthon-Derivat handelt.

17. Photopolymerisierbares Gemisch gemäß einem der Ansprüche 1 bis 2 und 5 bis 13, dadurch gekennzeichnet, daß es sich bei der Verbindung der allgemeinen Formel (I) um Chlorthioxanthon handelt.

18. Photopolymerisierbares Gemisch nach einem der Ansprüche 1 bis 10 und 13 bis 17, dadurch gekennzeichnet, daß es sich bei der Verbindung der allgemeinen Formel (II) um ein 2-Aryl-4,6-bis-(trichlormethyl)-s-triazin handelt.

19. Photopolymerisierbares Gemisch gemäß einem der Ansprüche 1 bis 18, dadurch gekennzeichnet, daß der Photoinitiator 10 bis 40 Gew.% der Komponente a) und 90 bis 60 Gew.% der Komponente b), jeweils bezogen auf die Summe der Komponenten (a) + (b), umfaßt.

**20.** Photopolymerisierbares Gemisch gemäß einem der Ansprüche 1 bis 19, dadurch gekennzeichnet, daß der Photopolymerisationsinitiator in einer Menge von 0,5 bis 15 Gew.%, bezogen auf das gesamte photopolymerisierbare Gemisch, enthalten ist, wobei 0,1 bis 5 Gew.%, bezogen auf das gesamte photopolymerisierbare Gemisch, der Komponente a) und 0,4 bis 10 Gew.%, bezogen auf das gesamte photopolymerisierbare Gemisch, der Komponente b) enthalten sind.

**21.** Lichtempfindliches Aufzeichnungselement mit einer auf einem dimensionsstabilen Träger aufgebrachten photopolymerisierbaren Aufzeichnungsschicht einer Dicke im Bereich von 0,1 bis 50 µm, dadurch gekennzeichnet, daß die photopolymerisierbare Aufzeichnungsschicht aus einem photopolymerisierbaren Gemisch gemäß einem der Ansprüche 1 bis 20 gebildet wird.

**22.** Lichtempfindliches Aufzeichnungselement gemäß Anspruch 21 für die Herstellung von Flachdruckformen, dadurch gekennzeichnet, daß es einen für Flachdruckplatten typischen Träger aufweist und die Dicke der photopolymerisierbaren Aufzeichnungsschicht im Bereich von 0,5 bis 8 µm liegt.

**23.** Lichtempfindliches Aufzeichnungselement gemäß einem der Ansprüche 21 oder 22, dadurch gekennzeichnet, daß die photopolymerisierbare Aufzeichnungsschicht gebildet wird aus einem homogenen, photopolymerisierbaren Gemisch, bestehend aus 0,5 bis 15 Gew.% des Photopolymerisationsinitiators aus den Komponenten a) und b), 8 bis 65 Gew.% mindestens eines ethylenisch ungesättigten, photopolymerisierbaren Monomeren, 30 bis 90 Gew.% mindestens eines mit den Monomeren verträglichen, nicht-photopolymerisierbaren bzw. nicht-photovernetzbaren polymeren Bindemittel sowie 0 bis 25 Gew.% an Zusatzund/oder Hilfsstoffen, wobei sich die Prozentangaben jeweils auf das gesamte photopolymerisierbare Gemisch beziehen.

**24.** Lichtempfindliches Aufzeichnungselement gemäß einem der Ansprüche 21 oder 22, dadurch gekennzeichnet, daß die photopolymerisierbare Aufzeichnungsschicht gebildet wird aus einem homogenen, photopolymerisierbaren Gemisch bestehend aus 0,5 bis 15 Gew.% des Photopolymerisationsinitiators aus den Komponenten a) und b), 70 bis 99,5 Gew.% mindestens eines ethylenisch ungesättigten, photopolymerisierbaren Oligomeren mit einem mittleren Molekulargewicht (Zahlenmittel) im Bereich von 1.000 bis 10.000, welches freie Carboxylgruppen und mindestens 2 Acryloyl- und/oder Methacryloyl-Gruppen enthaltende Reste im Molekül eingebaut enthält, 0 bis 10 Gew.% mindestens eines ethylenisch ungesättigten, photopolymerisierbaren Monomeren, welches mit den Oligomeren verträglich ist, 0 bis 10 Gew.% mindestens eines mit den Oligomeren sowie gegebenenfalls vorhandenen Monomeren verträglichen, nicht-photopolymerisierbaren und nicht-photovernetzbaren polymeren Bindemittels sowie 0 bis 10 Gew.% an Zusatz- und/oder Hilfsstoffen.

**25.** Lichtempfindliches Aufzeichnungselement gemäß Anspruch 24, dadurch gekennzeichnet, daß mindestens ein ethylenisch ungesättigtes, photopolymerisierbares Oligomers mit einem mittleren Molekulargewicht (Zahlenmittel) im Bereich von 1.000 bis 10.000, welches freie Carboxygruppen und mehr als 2 Acryloyl- und/oder Methacryloylgruppen enthaltende Reste im Molekül eingebaut enthält, eingesetzt wird.

**26.** Lichtempfindliches Aufzeichnungselement gemäß Anspruch 24 oder 25, dadurch gekennzeichnet, daß es sich bei den in der photopolymerisierbaren Aufzeichnungsschicht enthaltenen Oligomeren um oligomere, (Meth)acryloyl-Gruppen enthaltende Urethanharze handelt, wie sie erhältlich sind durch Umsetzung von (Meth)acryloyl-Gruppen enthaltenden Diol- oder Polyol-Verbindungen mit einem Diisocyanat, gegebenenfalls in Gegenwart niedermolekularer Diole als Kettenverlängerer, unter teilweiser Umsetzung der Hydroxylgruppen der Diol- oder Polyol-Komponente und Bildung eines hydroxylgruppenhaltigen oligomeren Urethanharzes sowie anschließende ganze oder teilweise Umsetzung der noch in dem Urethanharz vorhandenen freien Hydroxylgruppen mit einem cylischen Dicarbonsäureanhydrid unter Bildung der sauren Teilester der Dicarbonsäure.

**27.** Lichtempfindliches Aufzeichnungselement gemäß einem der Ansprüche 21 oder 22, dadurch gekennzeichnet, daß die photopolymerisierbare Aufzeichnungsschicht gebildet wird aus einem homogenen photopolymerisierbaren Gemisch, bestehend aus 0,5 bis 15 Gew.% des Photopolymerisationsinitiators aus den Komponenten a) und b), 75 bis 99,5 Gew.% einer Mischung von ethylenisch ungesättigten, photopolymerisierbaren bzw. photovernetzbaren Verbindungen sowie 0 bis 10 Gew.% an Zusatz- und/oder Hilfsstoffen, wobei sich die vorstehenden Prozentangaben jeweils auf das gesamte photopolymerisierbare Gemisch beziehen und wobei die Mischung aus den ethylenisch ungesättigten, photopolymerisierbaren Verbindungen gebildet wird aus mindestens einem ethylenisch ungesättigten, photopolymerisierbaren Monomeren und mindestens einem mit den Monomeren verträglichen photopolymerisierbaren bzw. photovernetzbaren Polymerisat, wobei das Gewichtsverhältnis von photopolymerisierbarem Monomeren zu photopolymerisierbarem bzw. photovernetzbarem Polymerisat im Bereich von 1:15 bis 1:1 liegt.

**28.** Verfahren zur Herstellung einer Flachdruckform, bei dem eine auf einem offsettypischen Trägermaterial haftfest aufgebrachte photopolymerisierbare Aufzeichnungsschicht eines lichtempfindlichen Aufzeichnungselementes bildweise mit aktinischem Licht belichtet wird und anschließend die nicht-belichteten Bereiche der photopolymerisierbaren Aufzeichnungsschicht entfernt werden, dadurch gekennzeichnet, daß in diesem Verfahren ein lichtempfindliches Aufzeichnungselement gemäß einem der Ansprüche 21 bis 27 eingesetzt wird.

**Patentansprüche für folgende Vertragsstaaten : AT, ES**

**1.** Verfahren zur Herstellung von Druckformen oder Resistmustern durch bildmäßiges Belichten mit aktinischem Licht einer auf einem dimensionsstabilen Träger aufgebrachten photopolymerisierbaren Aufzeichnungschicht eines lichtempfindlichen Aufzeichnungselements und anschließendes Entfernen der nicht-belichteten Bereiche der Photopolymerisierbaren Aufzeichnungsschicht, wobei die photopolymerisierbare Aufzeichnungsschicht des lichtempfindlichen Aufzeichnungselements gebildet wird aus einem photopolymerisierbaren Gemisch, enthaltend mindestens eine ethylenisch ungesättigte, photopolymerisierbare oder photovernetzbare Verbindung sowie einen Photopolymerisationsinitiator, dadurch gekennzeichnet, daß der Photopolymerisationsinitiator eine Kombination umfaßt von

a) einer Verbindung der allgemeinen Formel (I)

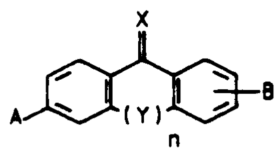

(I),

worin bedeuten

- A ein Wasserstoffatom, eine gegebenenfalls substituierte Alkylgruppe, eine $-NR^1R^2$-Gruppe (mit $R^1$, $R^2$ gleich oder verschieden und unabhängig voneinander einem Wasserstoffatom oder einem, gegebenenfalls substituierten, aliphatischen, aromatischen oder gemischt aliphatisch-aromatischen Rest) oder eine $-OR^3$-Gruppe (mit $R^3$ gleich einem Wasserstoffatom oder einem, gegebenenfalls substituierten, aliphatischen, aromatischen oder gemischt aliphatisch-aromatischen Rest),
- B einen Rest der unter A genannten Art (wobei die Reste A und B untereinander gleich oder verschieden sein können), ein Halogenatom oder die -C≡N-Gruppe,
- X ein Sauerstoffatom, ein Schwefelatom oder eine $=NR^4$-Gruppe (mit $R^4$ gleich einem Wasserstoffatom oder einem aliphatischen, aromatischen oder gemischt aliphatisch-aromatischen Rest),
- Y eine direkte Bindung, eine $-CH_2-$, $-CH_2-CH_2-$, -O-, -S-, -C(O)- oder $-NR^5$-Gruppierung (mit $R^5$ gleich einem Wasserstoffatom oder einem aliphatischen oder aromatischen Rest) und
- n 0 oder 1,

und

b) mindestens einer Verbindung der allgemeinen Formel (II)

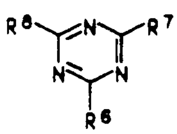

(II),

worin bedeuten

$R^6$, $R^7$, $R^8$ gleich oder verschieden, eine gegebenenfalls substituierte Alkylgruppe, eine gegebenenfalls substituierte Arylgruppe oder eine gegebenenfalls substituierte Aralkylgruppe, wobei mindestens einer der Reste $R^6$ bis $R^8$ eine mono-, di- oder trihalogensubstituierte Methylgruppe darstellt und einer der Reste $R^6$, $R^7$ oder $R^8$ auch eine gegebenenfalls substituierte Alkenylgruppe, eine $-NR_2$-, -OR- oder -SR-Gruppe sein kann, wobei R jeweils für ein Wasserstoffatom, eine Alkyl- oder eine Arylgruppe steht.

**2.** Verfahren gemäß Anspruch 1, dadurch gekennzeichnet, daß in der allgemeinen Formel (I) X ein Sauerstoffatom darstellt.

**3.** Verfahren gemäß einem der Ansprüche 1 oder 2, dadurch gekennzeichnet, daß in der allgemeinen Formel (I) n gleich 0 ist und die Reste A und B, gleich oder verschieden, jeweils ein Wasserstoffatom oder eine $-NR^1R^2$-Gruppe darstellen.

**4.** Verfahren gemäß Anspruch 3, dadurch gekennzeichnet, daß in der allgemeinen Formel (I) n gleich 0 ist und jeder der Reste A und B eine $-NR^1R^2$-Gruppe darstellt, worin $R^1$ und $R^2$ gleich oder verschieden sein können und eine Alkylgruppe mit 1 bis 4 C-Atomen, eine Hydroxyalkylgruppe mit 2 bis 3 C-Atomen oder zusammen unter Ausbildung eines heterocyclischen Ringes eine Alkylen-Gruppe mit 4 oder 5 C-Atomen darstellen.

**5.** Verfahren gemäß einem der Ansprüche 1 oder 2, dadurch gekennzeichnet, daß in der allgemeinen Formel (I) n gleich 1 ist und Y ein Sauerstoffatom, ein Schwefel oder die Carbonylgruppe darstellt.

**6.** Verfahren gemäß Anspruch 5, dadurch gekennzeichnet, daß in der allgemeinen Formel (I) n gleich 1 ist, Y ein Schwefelatom oder die Carbonylgruppe darstellt, A für ein Wasserstoffatom steht und B einen Alkylrest mit 1 bis 6 C-Atomen oder ein Halogenatom bedeutet.

**7.** Verfahren gemäß einem der Ansprüche 1 bis 6, dadurch gekennzeichnet, daß in der allgemeinen Formel (II) $R^6$ eine mono-, di-, oder trihalogensubstituierte Methylgruppe ist.

**8.** Verfahren nach einem der Ansprüche 1 bis 6, dadurch gekennzeichnet, daß in der allgemeinen Formel (II) $R^6$ Trichlormethyl oder Tribrommethyl ist.

**9.** Verfahren gemäß Anspruch 7 oder 8, dadurch gekennzeichnet, daß in der allgemeinen Formel (II) $R^7$ ebenfalls eine mono-, di- oder trihalogensubstituierte Methylgruppe ist.

**10.** Verfahren nach Anspruch 7 oder 8, dadurch gekennzeichnet, daß in der allgemeinen Formel (II) $R^7$ Trichlormethyl oder Tribrommethyl ist.

**11.** Verfahren gemäß einem der Ansprüche 1 bis 10, dadurch gekennzeichnet, daß in der allgemeinen Formel (II) $R^8$ eine Styrylgruppe der allgemeinen Formel

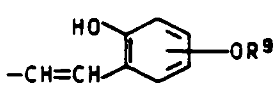

ist, worin $R^9$ für Wasserstoff, eine Alkylgruppe oder eine Arylgruppe steht.

**12.** Verfahren nach Anspruch 11, dadurch gekennzeichnet, daß die Verbindung der allgemeinen Formel (II) 2-(2′-Hydroxy-4′-methoxy-styryl)-4,6-bis-(trichlormethyl)-s-triazin ist.

**13.** Verfahren gemäß einem der Ansprüche 7 oder 9, dadurch gekennzeichnet, daß in der allgemeinen Formel (II) $R^8$ für einen gegebenenfalls substituierten Arylrest steht.

**14.** Verfahren nach einem der Ansprüche 1 bis 4 und 7 bis 13, dadurch gekennzeichnet, daß es sich bei der Verbindung der allgemeinen Formel (I) um Benzophenon oder ein Benzophenon-Derivat handelt.

15. Verfahren nach einem der Ansprüche 1 bis 4 und 7 bis 13, dadurch gekennzeichnet, daß es sich bei der Verbindung der allgemeinen Formel (I) um Michlers Keton handelt.

16. Verfahren gemäß einem der Ansprüche 1 bis 2 und 5 bis 13, dadurch gekennzeichnet, daß es sich bei der Verbindung der allgemeinen Formel (I) um Thioxanthon oder ein Thioxanthon-Derivat handelt.

17. Verfahren gemäß einem der Ansprüche 1 bis 2 und 5 bis 13, dadurch gekennzeichnet, daß es sich bei der Verbindung der allgemeinen Formel (I) um 2-Chlorthioxanthon handelt.

18. Verfahren nach einem der Ansprüche 1 bis 10 und 13 bis 17, dadurch gekennzeichnet, daß es sich bei der Verbindung der allgemeinen Formel (II) um ein 2-Aryl-4,6-bis-(trichlormethyl)-s-triazin handelt.

19. Verfahren gemäß einem der Ansprüche 1 bis 15, dadurch gekennzeichnet, daß der Photoinitiator 10 bis 40 Gew.% der Komponente a) und 90 bis 60 Gew.% der Komponente b), jeweils bezogen auf die Summe der Komponenten (a) + (b), umfaßt.

20. Verfahren gemäß einem der Ansprüche 1 bis 19, dadurch gekennzeichnet, daß der Photopolymerisationsinitiator in einer Menge von 0,5 bis 15 Gew.%, bezogen auf das gesamte photopolymerisierbare Gemisch, enthalten ist, wobei 0,1 bis 5 Gew.%, bezogen auf das gesamte photopolymerisierbare Gemisch, der Komponente a) und 0,4 bis 10 Gew,%, bezogen auf das gesamte photopolymerisierbare Gemisch, der Komponente b) enthalten sind.

21. Verfahren gemäß einem der Ansprüche 1 bis 20, dadurch gekennzeichnet, daß die photopolymerisierbare Aufzeichnungsschicht des lichtempfindlichen Aufzeichnungselements eine Dicke im Bereich von 0,1 bis 50 µm aufweist.

22. Verfahren gemäß einem der Ansprüche 1 bis 21 zur Herstellung von Flachdruckformen, dadurch gekennzeichnet, daß das lichtempfindliche Aufzeichnungselement einen für Flachdruckplatten typischen Träger aufweist und die Dicke der photopolymerisierbaren Aufzeichnungsschicht im Bereich von 0,5 bis 8 µm liegt.

23. Verfahren gemäß einem der Ansprüche 1 bis 22, dadurch gekennzeichnet, daß die photopolymerisierbare Aufzeichnungsschicht gebildet wird aus einem homogenen, photopolymerisierbaren Gemisch bestehend aus 0,5 bis 15 Gew.% des Photopolymerisationsinitiators aus den Komponenten a) und b), 8 bis 65 Gew.% mindestens eines ethylenisch ungesättigten, photopolymerisierbaren Monomeren, 30 bis 90 Gew.% mindestens eines mit den Monomeren verträglichen, nicht-photopolymerisierbaren bzw. nicht-photovernetzbaren polymeren Bindemittel sowie 0 bis 25 Gew.% an Zusatz-und/oder Hilfsstoffen, wobei sich die Prozentangaben jeweils auf das gesamte photopolymerisierbare Gemisch beziehen.

24. Verfahren gemäß einem der Ansprüche 1 bis 22, dadurch gekennzeichnet, daß die photopolymerisierbare Aufzeichnungsschicht gebildet wird aus einem homogen, photopolymerisierbaren Gemisch bestehend aus 0,5 bis 15 Gew.% des Photopolymerisationsinitiators aus den Komponenten a) und b), 70 bis 99,5 Gew.% mindestens eines ethylenisch ungesättigten, photopolymerisierbaren Oligomeren mit einem mittleren Molekulargewicht (Zahlenmittel) im bereich von 1.000 bis 10.000, welches freie Carboxylgruppen und mindestens 2 Acryloyl- und/oder Methylacryloyl-Gruppen enthaltende Reste im Molekül eingebaut enthält, 0 bis 10 Gew.% mindestens eines ethylenisch ungesättigten, photopolymerisierbaren Monomeren, welches mit den Oligomeren verträglich ist, 0 bis 10 Gew.% mindestens eines mit den Oligomeren sowie gegebenenfalls vorhandenen Monomeren verträglichen, nicht-photopolymerisierbaren und nicht-photovernetzbaren polymeren Bindemittels sowie 0 bis 10 Gew.% an Zusatz- und/oder Hilfsstoffen.

25. Verfahren gemäß Anspruch 24, dadurch gekennzeichnet, daß mindestens ein ethylenisch ungesättigtes, photopolymerisierbares Oligomers mit einem mittleren Molekulargewicht (Zahlenmittel) im Bereich von 1.000 bis 10.000, welches freie Carboxygruppen und mehr als 2 Acryloyl- und/oder Methacryloylgruppen enthaltende Reste im Molekül eingebaut enthält, eingesetzt wird.

26. Verfahren gemäß Anspruch 24 oder 25, dadurch gekennzeichnet, daß es sich bei den in der photopolymerisierbaren Aufzeichnungsschicht enthaltenen Oligomeren um oligomere, (Meth)acryloyl-Gruppen enthaltende Urethanharze handelt, wie sie erhältlich sind durch Umsetzung von (Meth)-acryloyl-Gruppen Diol-oder Polyol-Verbindungen mit einem Diisocyanat, gegebenenfalls in Gegenwart niedermolekularer Diole als Kettenverlängerer, unter teilweiser Umsetzung der Hydroxylgruppen der Diol- oder Polyol-Komponente und Bildung eines hydroxylgruppenhaltigen oligomeren Urethanharzes sowie anschließende ganze oder teilweise Umsetzung der noch in dem Urethanharz vorhandenen freien Hydroxylgruppen mit einem cyclischen Dicarbonsäureanhydrid unter Bildung der sauren Teilweise der Dicarbonsäure.

**27.** Verfahren gemäß einem der Ansprüche 1 bis 22, dadurch gekennzeichnet, daß die photopolymerisierbare Aufzeichnungsschicht gebildet wird aus einem homogenen photopolymerisierbaren Gemisch bestehend aus 0,5 bis 15 Gew.% des Photopolymerisationsinitiators aus den Komponenten a) und b), 75 bis 99,5 Gew.% einer Mischung von ethylenisch ungesättigten, photopolymerisierbaren bzw. photovernetzbaren Verbindungen sowie 0 bis 10 Gew.% an Zusatz-und/oder Hilfsstoffen, wobei sich die vorstehenden Prozentangaben jeweils auf das gesamte photopolymerisierbare Gemisch beziehen und wobei die Mischung aus den ethylenisch ungesättigten, photopolymerisierbaren Verbindungen gebildet wird aus mindestens einem ethylenisch ungesättigten, photopolymerisierbaren Monomeren und mindestens einem mit den Monomeren verträglichen photopolymerisierbaren bzw. photovernetzbaren Polymerisat, wobei das Gewichtsverhältnis von photopolymerisierbarem Monomeren zu photopolymerisierbarem bzw. photovernetzbarem Polymerisat im bereich von 1:15 bis 1:1 liegt.

**Claims**

**Claims for the following Contracting States : BE, CH, DE, FR, GB, IT, LI, NL, SE**

**1.** A photopolymerizable mixture containing one or more ethylenically unsaturated, photopolymerizable or photocrosslinkable compounds and a photopolymerization initiator, wherein the photopolymerization initiator comprises a combination of

a) a compound of the formula (I)

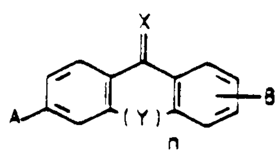

(I)

where A is hydrogen, unsubstituted or substituted alkyl, $-NR^1R^2$ (where $R^1$ and $R^2$ are identical or different and independently of one another are each hydrogen or an unsubstituted or substituted aliphatic, aromatic or mixed aliphatic-aromatic radical) or $-OR^3$ (where $R^3$ is hydrogen or an unsubstituted or substituted aliphatic, aromatic or mixed aliphatic-aromatic radical), B is a radical of the type stated under A (where A and B may be identical or different), halogen or the -C≡N group, X is oxygen, sulfur or a $=NR^4$ group (where $R^4$ is hydrogen or an aliphatic, aromatic or mixed aliphatic-aromatic radical), Y is a direct bond or a $-CH_2-$, $-CH_2-CH_2-$, -O-, -S-, -C(O)- or $-NR^5$ group (where $R^5$ is hydrogen or an aliphatic or aromatic radical) and n is 0 or 1,

and

b) one or more compounds of the general formula (II)

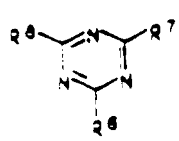

(II)

where $R^6$, $R^7$ and $R^8$ are identical or different and are each unsubstituted or substituted alkyl, unsubstituted or substituted aryl or unsubstituted or substituted aralkyl, and one or more of the radicals $R^6$, $R^7$ and $R^8$ are mono-, di- or trihalogen-substituted methyl and one of the radicals $R^6$, $R^7$ or $R^8$ may furthermore be unsubstituted or substituted alkenyl or an $-NR_2-$, -OR- or -SR- group, where R in each case is hydrogen, alkyl or aryl.

**2.** A photopolymerizable mixture as claimed in claim 1, wherein, in the general formula (I), X is oxygen.

**3.** A photopolymerizable mixture as claimed in claim 1 or 2, wherein, in the general formula (I), n is 0 and A and B are identical or different and are each hydrogen or an $-NR^1R^2$ group.

**4.** A photopolymerizable mixture as claimed in claim 3, wherein, in the general formula (I), n is 0 and wherein each of the radicals A and B is an $-NR^1R^2$ group, where $R^1$ and $R^2$ can be identical or different and are each alkyl of 1 to 4 carbon atoms or hydroxyalkyl of 2 or 3 carbon atoms, or together constitute an alkylene group of 4 to 5 carbon atoms and form a heterocyclic ring.

**5.** A photopolymerizable mixture as claimed in claim 1 or 2, wherein, in the general formula (I), n is 1 and Y is oxygen, sulfur or carbonyl.

**6.** A photopolymerizable mixture as claimed in claim 5, wherein, in the general formula (I), n is 1, Y is sulfur or carbonyl, A is hydrogen and B is alkyl of 1 to 6 carbon atoms or halogen.

**7.** A photopolymerizable mixture as claimed in one of claims 1 to 6, wherein, in the general formula (II), $R^6$ is mono-, di- or trihalogen-substituted methyl.

**8.** A photopolymerizable mixture as claimed in one of claims 1 to 6, wherein, in the general formula (II), $R^6$ is trichloromethyl or tribromomethyl.

**9.** A photopolymerizable mixture as claimed in claim 7 or 8, wherein, in the general formula (II), $R^7$ is likewise mono-, di- or trihalogen-substituted methyl.

**10.** A photopolymerizable mixture as claimed in claim 7 or 8, wherein, in the general formula (II), $R^7$ is trichloromethyl or tribromomethyl.

**11.** A photopolymerizable mixture as claimed in one of claims 1 to 10, wherein, in the general formula (II), $R^8$ is styryl of the general formula

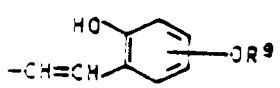

where $R^9$ is hydrogen, alkyl or aryl.

**12.** A photopolymerizable mixture as claimed in claim 11, wherein the compound of the general formula (II) is 2-(2'-hydroxy-4'-methoxystyryl)-4,6-bis-(trichloromethyl)-s-triazine.

**13.** A photopolymerizable mixture as claimed in one of claims 7 to 10, wherein, in the general formula (II), $R^8$ is unsubstituted or substituted aryl.

**14.** A photopolymerizable mixture as claimed in claims 1 to 4 and 7 to 13, wherein the compound of the general formula (I) is benzophenone or a benzophenone derivative.

**15.** A photopolymerizable mixture as claimed in one of claims 1 to 4 and 7 to 13, wherein the compound of the formula (I) is Michler's ketone.

**16.** A photopolymerizable mixture as claimed in one of claims 1 and 2 and 5 to 13, wherein the compound of the general formula (I) is thioxanthone or a thioxanthone derivative.

**17.** A photopolymerizable mixture as claimed in one of claims 1 or 2 and 5 to 13, wherein the compound of the formula (I) is chlorothioxanthone.

**18.** A photopolymerizable mixture as claimed in one of claims 1 to 10 and 13 to 17, wherein the compound of the general formula (II) is a 2-aryl-4,6-bis-(trichloromethyl)-s-triazine.

**19.** A photopolymerizable mixture as claimed in one of claims 1 to 18, wherein the photoinitiator comprises from 10 to 40% by weight of component a) and from 90 to 60% by weight of component b), based in each case on the sum of the components a) + b).

**20.** A photopolymerizable mixture as claimed in one of claims 1 to 19, wherein the photopolymerization initiator is present in an amount of from 0.5 to 15% by weight, from 0.1 to 5% by weight of component a) and from 0.4 to 10% by weight of component b) being present, the percentages in each case being based on the total photopolymerizable mixture.

**21.** A photosensitive recording element having a photopolymerizable recording layer which is from 0.1 to 50 µm thick and is applied on a dimensionally stable base, wherein the said recording layer consists of a photopolymerizable mixture as claimed in one of claims 1 to 20.

**22.** A photosensitive recording element as claimed in claim 21 for the production of a lithographic printing plate, wherein the said element has a base typically used for lithographic printing plates and the thickness of the photopolymerizable recording layer is from 0.5 to 8 µm.

**23.** A photosensitive recording element as claimed in claim 21 or 22, wherein the photopolymerizable recording layer is formed from a homogeneous, photopolymerizable mixture consisting of from 0.5 to 15% by weight of the photopolymerization initiator comprising the components a) and b), from 8 to 65% by weight of one or more ethylenically unsaturated, photopolymerizable monomers, from 30 to 90% by weight of one or more nonphotopolymerizable and nonphotocrosslinkable polymeric binders which are compatible with monomers and from 0 to 25% by weight of additives and/or assistants, the percentages in each case being based on the total photopolymerizable mixture.

**24.** A photosensitive recording element as claimed in claim 21 or 22, wherein the photopolymerisable recording layer is formed from a homogeneous, photopolymerizable mixture consisting of from 0.5 to 15% by weight of the photopolymerization initiator comprising the components a) and b), from 70 to 99.5% by weight of one or more ethylenically unsaturated, photopolymerizable oligomers having a mean molecular weight (number average) of from 1,000 to 10,000 and containing free carboxyl groups and not less than 2 radicals possessing acryloyl and/or methacryloyl groups incorporated in the molecule, from 0 to 10% by weight of one or more ethylenically unsaturated, photopolymerizable monomers which are compatible with the oligomers, from 0 to 10% by weight of one or more nonphotopolymerizable and nonphotocrosslinkable polymeric binders which are compatible with the oligomers and any monomers present, and from 0 to 10% by weight of additives and/or assistants.

**25.** A photosensitive recording element as claimed in claim 24, wherein one or more ethylenically unsaturated, photopolymerizable oligomers having a mean molecular weight (number average) of from 1,000 to 10,000 and containing free carboxyl groups and not less than 2 radicals possessing acryloyl and/or methacryloyl groups incorporated in the molecule, are employed.

**26.** A photosensitive recording element as claimed in claim 24 or 25, wherein the oligomers present in the photopolymerizable recording layer are oligomeric, (meth)acryloyl-containing urethane resins as are obtainable by reacting (meth)acryloyl-containing diol or polyol compounds with a diisocyanate in the presence or absence of low molecular weight diols as chain extenders, with conversion of some of the hydroxyl groups of the diol or polyol components and formation of the hydroxyl-containing oligomeric urethane resin, and then reacting some or all of the free hydroxyl groups still present in the urethane resin with a cyclic dicarboxylic anhydride with formation of the acidic partial ester of the dicarboxylic acid.

**27.** A photosensitive recording element as claimed in claim 21 or 22, wherein the photopolymerizable recording layer is formed from a homogeneous photopolymerizable mixture consisting of from 0.5 to 15% by weight of the photopolymerization initiator comprising the components a) and b), from 75 to 99.5% by weight of a mixture of ethylenically unsaturated, photopolymerizable or photocrosslinkable compounds and from 0 to 10% by weight of additives and/or assistants, the above percentages in each case being based on the total photopolymerizable mixture, and the mixture of the ethylenically unsaturated, photopolymerizable compounds consisting of one or more ethylenically unsaturated, photopolymerizable monomers and one or more photopolymerizable or photocrosslinkable polymers

which are compatible with the monomers and the weight ratio of photopolymerizable monomer to photopolymerizable or photocrosslinkable polymer being from 1:15 to 1:1.

**28.** A process for the production of a lithographic printing plate, in which a photopolymerizable recording layer of a photosensitive recording element, the said layer being firmly bonded to a base typically used in offset printing, is exposed imagewise to actinic light and the unexposed parts of the photopolymerizable recording layer are then removed, wherein, in this process, a photosensitive recording element as claimed in one of claims 21 to 27 is employed.

**Claims for the following Contracting States : AT, ES**

**1.** A process for the production of a printing plate or resist image by imagewise exposure, to actinic light, of a photopolymerizable recording layer of a photosensitive recording element, which layer is applied to a dimensionally stable substrate, and subsequent removal of the unexposed parts of the photopolymerizable recording layer, which is formed from a photopolymerizable mixture containing at least one ethylenically unsaturated, photopolymerizable or photocrosslinkable compound and a photopolymerization initiator, wherein the photopolymerization initiator comprises a combination of

a) a compound of the formula (I)

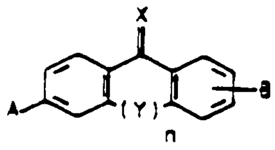

(I)

where A is hydrogen, unsubstituted or substituted alkyl, $-NR^1R^2$ (where $R^1$ and $R^2$ are identical or different and independently of one another are each hydrogen or an unsubstituted or substituted aliphatic, aromatic or mixed aliphatic-aromatic radical) or $-OR^3$ (where $R^3$ is hydrogen or an unsubstituted or substituted aliphatic, aromatic or mixed aliphatic-aromatic radical), B is a radical of the type stated under A (where A and B may be identical or different), halogen or the -C≡N group, X is oxygen, sulfur or a $=NR^4$ group (where $R^4$ is hydrogen or an aliphatic, aromatic or mixed aliphatic-aromatic radical), Y is a direct bond or a $-CH_2-$, $-CH_2-CH_2-$, -O, -S-, -C(O)- or $-NR^5$ group (where $R^5$ is hydrogen or an aliphatic or aromatic radical) and n is 0 or 1,

and

b) one or more compounds of the general formula (II)

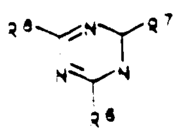

(II)

where $R^6$, $R^7$ and $R^8$ are identical or different and are each unsubstituted or substituted alkyl, unsubstituted or substituted aryl or unsubstituted or substituted aralkyl, and one or more of the radicals $R^6$, $R^7$ and $R^8$ are mono-, di- or trihalogen-substituted methyl and one of the radicals $R^6$, $R^7$ or $R^8$ may furthermore be unsubstituted or substituted alkenyl or an $-NR_2-$, -OR- or -SR- group, where R in each case is hydrogen, alkyl or aryl.

**2.** A process as claimed in claim 1, wherein, in the general formula (I), X is oxygen.

**3.** A process as claimed in claim 1 or 2, wherein, in the general formula (I), n is 0 and A and B are identical or different and are each hydrogen or an $-NR^1R^2$ group.

**4.** A process as claimed in claim 3, wherein, in the general formula (I), n is 0 and wherein each of the radicals A and B is an $-NR^1R^2$ group, where $R^1$ and $R^2$ can be identical or different and are each alkyl of 1 to 4 carbon atoms or hydroxyalkyl of 2 or 3 carbon atoms, or together constitute an alkylene group of 4 to 5 carbon atoms and form a heterocyclic ring.

**5.** A process as claimed in claim 1 or 2, wherein, in the general formula (I), n is 1 and Y is oxygen, sulfur or carbonyl.

**6.** A process as claimed in claim 5, wherein, in the general formula (I), n is 1, Y is sulfur or carbonyl, A is hydrogen and B is alkyl of 1 to 6 carbon atoms or halogen.

**7.** A process as claimed in one of claims 1 to 6, wherein, in the general formula (II), $R^6$ is mono-, di- or trihalogen-substituted methyl.

**8.** A process as claimed in any of claims 1 to 6, wherein, in the general formula (II), $R^6$ is trichloromethyl or tribromomethyl.

**9.** A process as claimed in claim 7 or 8, wherein, in the general formula (II), $R^7$ is likewise mono-, di- or trihalogen-substituted methyl.

**10.** A process as claimed in claim 7 or 8, wherein, in the general formula (II), $R^7$ is trichloromethyl or tribromomethyl.

**11.** A process as claimed in one of claims 1 to 10, wherein, in the general formula (II), $R^8$ is styryl of the general formula

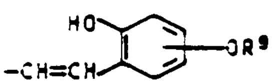

where $R^9$ is hydrogen, alkyl or aryl.

**12.** A process as claimed in claim 11, wherein the compound of the general formula (II) is 2-(2'-hydroxy-4'-methoxystyryl)-4,6-bis-(trichloromethyl)-s-triazine.

**13.** A process as claimed in one of claims 7 or 9, wherein, in the general formula (II), $R^8$ is unsubstituted or substituted aryl.

**14.** A process as claimed in claims 1 to 4 and 7 to 13, wherein the compound of the general formula (I) is benzophenone or a benzophenone derivative.

**15.** A process as claimed in one of claims 1 to 4 and 7 to 13, wherein the compound of the formula (I) is Michler's ketone.

**16.** A process as claimed in one of claims 1 and 2 and 5 to 13, wherein the compound of the general formula (I) is thioxanthone or a thioxanthone derivative.

**17.** A process as claimed in one of claims 1 or 2 and 5 to 13, wherein the compound of the formula (I) is 2-chlorothioxanthone.

**18.** A process as claimed in one of claims 1 to 10 and 13 to 17, wherein the compound of the general formula (II) is a 2-aryl-4,6-bis-(trichloromethyl)-s-triazine.

**19.** A process as claimed in one of claims 1 to 15, wherein the photoinitiator comprises from 10 to 40% by weight of component a) and from 90 to 60% by weight of component b), based in each case on the sum of the components a) + b).

**20.** A process as claimed in one of claims 1 to 19, wherein the photopolymerization initiator is present in an amount of from 0.5 to 15% by weight, from 0.1 to 5% by weight of component a) and from 0.4 to 10% by weight of component b) being present, the percentages in each case being based on the total photopolymerizable mixture.

21. A process as claimed in one of claims 1 to 20, wherein the photopolymerizable recording layer of the photosensitive recording element is from 0.1 to 50 µm thick.

22. A process as claimed in one of claims 1 to 21 for the production of a lithographic printing plate, wherein the photosensitive recording element has a base typically used for lithographic printing plates and the thickness of the photopolymerizable recording layer is from 0.5 to 8 µm.

23. A process as claimed in one of claims 1 to 22, wherein the photopolymerizable recording layer is formed from a homogeneous, photopolymerizable mixture consisting of from 0.5 to 15% by weight of the photopolymerization initiator comprising the components a) and b), from 8 to 65% by weight of one or more ethylenically unsaturated, photopolymerizable monomers, from 30 to 90% by weight of one or more nonphotopolymerizable and nonphotocrosslinkable polymeric binders which are compatible with monomers and from 0 to 25% by weight of additives and/or assistants, the percentages in each case being based on the total photopolymerizable mixture.

24. A process as claimed in one of claims 1 to 22, wherein the photopolymerizable recording layer is formed from a homogeneous, photopolymerizable mixture consisting of from 0.5 to 15% by weight of the photopolymerization initiator comprising the components a) and b), from 70 to 99.5% by weight of one or more ethylenically unsaturated, photopolymerizable oligomers having a mean molecular weight (number average) of from 1,000 to 10,000 and containing free carboxyl groups and not less than 2 radicals possessing acryloyl and/or methacryloyl groups incorporated in the molecule, from 0 to 10% by weight of one or more ethylenically unsaturated, photopolymerizable monomers which are compatible with the oligomers, from 0 to 10% by weight of one or more nonphotopolymerizable and nonphotocrosslinkable polymeric binders which are compatible with the oligomers and any monomers present, and from 0 to 10% by weight of additives and/or assistants.

25. A process as claimed in claim 24, wherein one or more ethylenically unsaturated, photopolymerizable oligomers having a mean molecular weight (number average) of from 1,000 to 10,000 and containing free carboxyl groups and not less than 2 radicals possessing acryloyl and/or methacryloyl groups incorporated in the molecule, are employed.

26. A process as claimed in claim 24 or 25, wherein the oligomers present in the photopolymerizable recording layer are oligomeric, (meth)acryloyl-containing urethane resins as are obtainable by reacting (meth)acryloyl-containing diol or polyol compounds with a diisocyanate in the presence or absence of low molecular weight diols as chain extenders, with conversion of some of the hydroxyl groups of the diol or polyol components and formation of the hydroxyl-containing oligomeric urethane resin, and then reacting some or all of the free hydroxyl groups still present in the urethane resin with a cyclic dicarboxylic anhydride with formation of the acidic partial ester of the dicarboxylic acid.

27. A process as claimed in one of claims 1 to 22, wherein the photopolymerizable recording layer is formed from a homogeneous photopolymerizable mixture consisting of from 0.5 to 15% by weight of the photopolymerization initiator comprising the components a) and b), from 75 to 99.5% by weight of a mixture of ethylenically unsaturated, photopolymerizable or photocrosslinkable compounds and from 0 to 10% by weight of additives and/or assistants, the above percentages in each case being based on the total photopolymerizable mixture, and the mixture of the ethylenically unsaturated, photopolymerizable compounds consisting of one or more ethylenically unsaturated, photopolymerizable monomers and one or more photopolymerizable or photocrosslinkable polymers which are compatible with the monomers and the weight ratio of photopolymerizable monomer to photopolymerizable or photocrosslinkable polymer being from 1:15 to 1:1.

**Revendications**
**Revendications pour les Etats contractants suivants : BE, CH, DE, FR, GB, IT, LI, NL, SE**

1. Mélange photopolymérisable, contenant au moins un composé à insaturation éthylénique photopolymérisable ou photoréticulable et un inducteur de photopolymérisation, caractérisé en ce que l'inducteur de photopolymérisation consiste en une combinaison de :
   a) composé de formule générale I

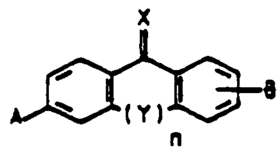

(I),

dans laquelle
A représente un atome d'hydrogène, un groupe alkyle éventuellement substitué, un groupe $-NR^1R^2$ (dans lequel $R^1$ et $R^2$, identiques ou différents, représentent chacun, indépendamment l'un de l'autre, un atome d'hydrogène ou un groupe aliphatique, aromatique ou mixte aliphatique-aromatique éventuellement substitué) ou un groupe $-OR^3$ (dans lequel $R^3$ représente un atome d'hydrogène ou un groupe aliphatique, aromatique ou mixte aliphatique-aromatique éventuellement substitué),
B a les mêmes significations que A (mais A et B peuvent être identiques ou différents), ou représente un atome d'halogène ou le groupe -C≡N,
X représente un atome d'hydrogène, un atome de soufre ou un groupe $=NR^4$ (dans lequel $R^4$ représente un atome d'hydrogène ou un groupe aliphatique, aromatique ou mixte aliphatique-aromatique),
Y représente une liaison directe, un groupe $-CH_2-$, $-CH_2-CH_2-$, -O-, -S-, -C(O)- ou $-NR^5-$ (dans lequel $R^5$ représente un atome d'hydrogène ou un groupe aliphatique ou aromatique), et
n est égal à 0 ou 1,
et
b) au moins un composé de formule générale

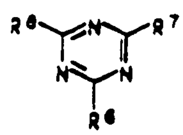

(II),

dans laquelle
$R^6$, $R^7$ et $R^8$, identiques ou différents, représentent chacun un groupe alkyle éventuellement substitué, un groupe aryle éventuellement substitué ou un groupe aralkyle éventuellement substitué, l'un au moins des symboles $R^6$ à $R^8$ devant représenter un groupe méthyle mono-, di- ou tri-halogéné, et l'un des symboles $R^6$, $R^7$ ou $R^8$ pouvant également représenter un groupe alcényle éventuellement substitué, un groupe $-NR^2$, -OR ou -SR, R représentant dans chaque cas un atome d'hydrogène, un groupe alkyle ou aryle.

**2.** Mélange photopolymérisable selon la revendication 1, caractérisé en ce que, dans la formule générale I, X représente un atome d'oxygène.

**3.** Mélange photopolymérisable selon une des revendications 1 ou 2, caractérisé en ce que, dans la formule générale I, n est égal à 0 et les symboles A et B, ayant des significations identiques ou différentes, représentent chacun un atome d'hydrogène ou un groupe - $NR^1R^2$.

**4.** Mélange photopolymérisable selon la revendication 3, caractérisé en ce que, dans la formule générale I, n est égal à 0 et chacun des symboles A et B représente un groupe $-NR^1R^2$ dans lequel $R^1$ et $R^2$ peuvent avoir des significations identiques ou différentes et représentent chacun un groupe alkyle en C 1-C 4, un groupe hydroxyalkyle en C 2-C 3 ou forment ensemble un groupe alkylène en C 4 ou C 5 complétant un noyau hétérocyclique.

**5.** Mélange photopolymérisable selon une des revendications 1 ou 2, caractérisé en ce que, dans la formule générale I, n est égal à 1 et Y représente un atome d'oxygène, un atome de soufre ou le groupe carbonyle.

**6.** Mélange photopolymérisable selon la revendication 5, caractérisé en ce que, dans la formule générale I, n est égal à 1, Y représente un atome de soufre ou le groupe carbonyle, A représente un atome d'hydrogène et B un groupe alkyle en C 1-C 6 ou un atome d'halogène.

**7.** Mélange photopolymérisable selon l'une des revendications 1 à 6, caractérisé en ce que, dans la formule générale II, $R^6$ représente un groupe méthyle mono-, di- ou tri-halogéné.

**8.** Mélange photopolymérisable selon l'une des revendications 1 à 6, caractérisé en ce que, dans la formule générale II, $R^6$ représente un groupe trichlorométhyle ou tribromométhyle.

**9.** Mélange photopolymérisable selon la revendication 7 ou 8, caractérisé en ce que, dans la formule générale II, $R^7$ représente également un groupe méthyle mono-, di-ou tri-halogéné.

**10.** Mélange photopolymérisable selon la revendication 7 ou 8, caractérisé en ce que, dans la formule générale II, $R^7$ représente un groupe trichlorométhyle ou tribromométhyle.

**11.** Mélange photopolymérisable selon l'une des revendications 1 à 10, caractérisé en ce que, dans la formule générale II, $R^8$ représente un groupe styryle de formule générale

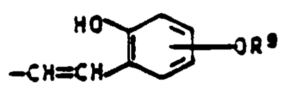

dans laquelle $R^9$ représente l'hydrogène, un groupe alkyle ou aryle.

**12.** Mélange photopolymérisable selon la revendication 11, caractérisé en ce que le composé de formule générale II est la 2-(2'-hydroxy-4'-méthoxy-styryl)-4,6-bis-(trichlorométhyl)-s-triazine.

**13.** Mélange photopolymérisable selon l'une des revendication 7 à 10, caractérisé en ce que, dans la formule générale II, $R^8$ représente un groupe aryle éventuellement substitué.

**14.** Mélange photopolymérisable selon l'une des revendications 1 à 4 et 7 à 13, caractérisé en ce que le composé de formule générale I est la benzophénone ou un dérivé de la benzophénone.

**15.** Mélange photopolymérisable selon l'une des revendications 1 à 4 et 7 à 13, caractérisé en ce que le composé de formule générale I est la cétone de Michler.

**16.** Mélange photopolymérisable selon l'une des revendications 1 à 2 et 5 à 13, caractérisé en ce que le composé de formule générale I est la thioxanthone ou un dérivé de la thioxanthone.

**17.** Mélange photopolymérisable selon l'une des revendications 1 à 2 et 5 à 13, caractérisé en ce que le composé de formule générale I est la chlorothioxanthone.

**18.** Mélange photopolymérisable selon l'une des revendications 1 à 10 et 13 à 17, caractérisé en ce que le composé de formule générale II est une 2-aryl-4,6-bis-(trichlorométhyl)-s-triazine.

**19.** Mélange photopolymérisable selon l'une des revendications 1 à 18, caractérisé en ce que le photoinducteur est constitué de 10 à 40 % en poids du composant a) et 90 à 60 % en poids du composant b), dans les deux cas par rapport à la somme des composants a) + b).

**20.** Mélange photopolymérisable selon l'une des revendications 1 à 19, caractérisé en ce que l'inducteur de photopolymérisation est contenu en quantité de 0,5 à 15 % du poids du mélange photopolymérisable total, à raison de 0,1 à 5 % en poids, par rapport au mélange photopolymérisable total, du composant a) et de 0,4 ) 10 % en poids, par rapport au mélange photopolymérisable total, du composant b).

**21.** Elément d'enregistrement photosensible à couche d'enregistrement d'une épaisseur de 0,1 à 50 µm appliquée sur un support à dimensions stables, caractérisé en ce que la couche d'enregistrement photopolymérisable est constituée d'un mélange photopolymérisable selon l'une des revendications 1 à 20.

**22.** Elément d'enregistrement photosensible selon la revendication 21, pour la préparation de formes d'impression à plat, caractérisé en ce qu'il comprend un support typique pour plaques d'impression à plat et en ce que l'épaisseur de la couche d'enregistrement photopolymérisable se situe dans l'intervalle de 0,5 à 8 µm.

**23.** Elément d'enregistrement photosensible selon l'une des revendications 21 ou 22, caractérisé en ce que la couche d'enregistrement photopolymérisable est constituée d'un mélange homogène photopolymérisable consistant lui-même en 0,5 à 15 % en poids de l'inducteur de photopolymérisation formé des composants a) et b), 8 à 65 % en poids d'au moins un monomère à insaturation éthylénique photopolymérisable, 30 à 90 % en poids d'au moins un liant polymère compatible avec les monomères, non photopolymérisable ni photoréticulable, et 0 à 25 % en poids d'additifs et/ou produits auxiliaires, toutes les indications de pourcentage se rapportant au mélange photopolymérisable total.

**24.** Elément d'enregistrement photosensible selon l'une des revendications 21 ou 22, caractérisé en ce que la couche d'enregistrement photopolymérisable est constituée d'un mélange homogène photopolymérisable consistant lui-même en 0,5 à 15 % en poids de l'inducteur de photopolymérisation formé des composants a) et b), 70 à 99,5 % en poids d'un moins un oligomère à insaturation éthylénique photopolymérisable, de poids moléculaire moyen (moyenne en nombre) dans l'intervalle de 1000 à 10 000, contenant dans la molécule des groupes carboxyle libres et au moins deux radicaux contenant des groupes acryloyle et/ou méthacryloyle, 0 à 10 % en poids d'au moins un monomère à insaturation éthylénique photopolymérisale compatible avec les oligomères, 0 à 10 % en poids d'au moins un liant polymère compatible avec les oligomères et avec les monomères éventuellement présents, non photopolymérisable ni photoréticulable, et 0 à 10 % en poids d'additifs et/ou produits auxiliaires.

**25.** Elément d'enregistrement photosensible selon la revendication 24, caractérisé en ce que l'on utilise au moins un oligomère à insaturation éthylénique photopolymérisable, de poids moléculaire moyen (moyenne en nombre) dans l'intervalle de 1000 à 10 000, qui contient dans la molécule des groupes carboxyle libres et plus de deux radicaux contenant des groupes acryloyle et/ou méthacryloyle.

**26.** Elément d'enregistrement photosensible selon la revendication 24 ou 25, caractérisé en ce que les oligomères contenus dans la couche d'enregistrement photopolymérisable sont des résines d'uréthannes oligomères contenant des groupes (méth)acryloyle, telles qu'on peut les obtenir par réaction de diols ou polyols contenant des groupes (méth)acryloyle avec un diisocyanate, éventuellement en présence de diols à bas poids moléculaire servant d'agents d'allongement des chaînes, avec réaction partielle des groupes hydroxy du diol ou polyol et formation d'une résine d'uréthanne oligomère contenant des groupes hydroxy, suivie d'une réaction complète ou partielle des groupes hydroxy libres encore présents dans la résine d'uréthanne avec un anhydride d'acide dicarboxylique cyclique, avec formation de l'ester partiel acide de l'acide dicarboxylique.

**27.** Elément d'enregistrement photosensible selon l'une des revendications 21 ou 22, caractérisé en ce que la couche d'enregistrement photopolymérisable est constituée d'un mélange homogène photopolymérisable consistant lui-même en 0,5 à 15 % en poids de l'inducteur de photopolymérisation formé des composants a) et b), 75 à 99,5 % en poids d'un mélange de composés à insaturation éthylénique photopolymérisables ou photoréticulables et 0 à 10 % en poids d'additifs et/ou produits auxiliares, toutes les indications de pourcentage données se rapportant au mélange photopolymérisable total, et le mélange des composés à insaturation éthylénique photopolymérisables consiste en au moins un monomère à insaturation éthylénique photopolymérisable et au moins un polymère compatible avec les monomères, photopolymérisable ou photoréticulable, les proportions relatives en poids entre les monomères photopolymérisables et les polymères photopolymérisables ou photoréticulables se situant dans l'intervalle de 1:15 à 1:1.

**28.** Procédé de préparation d'une forme d'impression à plat dans lequel on expose à la lumière actinique avec formation d'une image une couche d'enregistrement photopolymérisable appliquée solidement sur

une matière de support typique de l'impression en offset et on élimine ensuite les régions non exposés de la couche d'enregistrement photopolymérisable, caractérisé en ce que, dans ce procédé, on utilise un élément d'enregistrement photosensible selon l'une des revendications 21 à 27.

**Revendications pour les Etats contractants suivants : AT, ES**

**1.** Procédé de préparation de formes d'impression ou modèles de réserve par exposition à la lumière actinique avec formation d'une image d'une couche d'enregistrement photopolymérisable d'un élément d'enregistrement photosensible appliquée sur un support à dimensions stables et élimination subséquente des régions non exposées de la couche d'enregistrement photopolymérisable, dans lequel la couche d'enregistrement photopolymérisable de l'élément d'enregistrement photosensible est constituée d'un mélange photopolymérisable contenant au moins un composé à insaturation éthylénique photopolymérisable un photoréticulable et un inducteur de photopolymérisation, caractérisé en ce que l'inducteur de photopolymérisation consiste en une combinaison de :

a) un composé de formule générale I

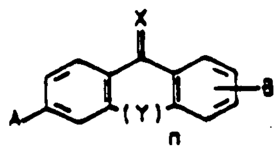

(I).

dans laquelle
A représente un atome d'hydrogène, un groupe alkyle éventuellement substitué, un groupe $-NR^1R^2$ (dans lequel $R^1$ et $R^2$, identiques ou différents, représentent chacun, indépendamment l'une de l'autre, un atome d'hydrogène ou un groupe aliphatique, aromatique ou mixte aliphatique-aromatique éventuellement substitué ) ou un groupe $OR^3$ (dans lequel $R^3$ représente un atome d'hydrogène ou un groupe aliphatique, aromatique ou mixte aliphatique-aromatique éventuellement substitué),
B a les mêmes significations que A (mais A et B, indépendants l'un de l'autre, peuvent être identiques ou différents), ou représente un atome d'halogène ou le groupe -C≡N,
X représente un atome d'hydrogène, un atome de soufre ou un groupe $=NR^4$ (dans lequel $R^4$ représente un atome d'hydrogène ou un groupe aliphatique, aromatique ou mixte aliphatique-aromatique),
Y représente une liaison directe, un groupe $-CH_2-$, $-CH_2-CH_2-$, -O-, -S-, -C(O)- ou $-NR^5$ (dans lequel $R^5$ représente un atome d'hydrogène ou un groupe aliphatique ou aromatique), et
n est égal à 0 ou 1,
et

b) au moins un composé de formule générale II

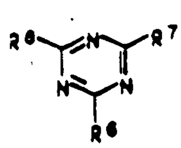

(II).

dans laquelle
$R^6$, $R^7$ et $R^8$, identiques ou différents, représentent chacun un groupe alkyle éventuellement substitué, un groupe aryle éventuellement substitué ou un groupe aralkyle éventuellement substitué, au moins un des symboles $R^6$ à $R^8$ représentant un groupe méthyle mono-, di- ou tri-halogéné, et l'un des symboles $R^6$, $R^7$ et $R^8$ peut également représenter un groupe alcényle éventuellement substitué, un groupe $-NR^2-$, -OR- ou -SR-, R représentant dans tous les cas un atome d'hydrogène, un groupe alkyle ou aryle.

**2.** Procédé selon la revendication 1, caractérisé en ce que, dans la formule générale I, X représente un atome d'oxygène.

**3.** Procédé selon l'une des revendications 1 ou 2, caractérisé en ce que, dans la formule générale I, n est égal à 0 et les symboles A et B, ayant des significations identiques ou différentes, représentent chacun un atome d'hydrogène ou un groupe $-NR^1R^2$.

**4.** Procédé selon la revendication 3, caractérisé en ce que, dans la formule générale I, n est égal à 0 et chacun des symboles A et B représente un groupe $-NR^1R^2$ dans lequel $R^1$ et $R^2$, identiques ou différents, représentent chacun un groupe alkyle en C 1-C 4, un groupe hydroxyalkyle en C 2-C 3, ou forment ensemble un groupe alkylène en C 4 ou C 5 complétant un noyau hétérocyclique.

**5.** Procédé selon l'une des revendications 1 ou 2, caractérisé en ce que, dans la formule générale I, n est égal à 1 et Y représente un atome d'oxygène, un atome de soufre ou le groupe carbonyle.

**6.** Procédé selon la revendication 5, caractérisé en ce que, dans la formule générale I, n est égal à 1, Y représente un atome de soufre ou le groupe carbonyle,
A représente un atome d'hydrogène et B un groupe alkyle en C 1-C 6 ou un atome d'halogène.

**7.** Procédé selon l'une des revendications 1 à 6, caractérisé en ce que, dans la formule générale II, $R^6$ représente un groupe méthyle mono-, di- ou tri-halogéné.

**8.** Procédé selon l'une des revendications 1 à 6, caractérisé en ce que, dans la formule générale II, $R^6$ représente un groupe trichlorométhyle ou tribromométhyle.

**9.** Procédé selon la revendication 7 ou 8, caractérisé en ce que, dans la formule générale II, $R^7$ représente également un groupe méthyle mono-, di- ou tri-halogéné.

**10.** Procédé selon la revendication 7 ou 8,caractérisé en ce que, dans la formule générale II, $R^7$ représente un groupe trichlorométhyle ou tribromométhyle.

**11.** Procédé selon l'une des revendications 1 à 10, caractérisé en ce que, dans la formule générale II, $R^8$ représente un groupe styryle de formule générale

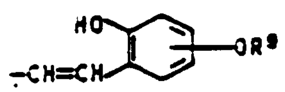

dans laquelle $R^9$ représente l'hydrogène, un groupe alkyle ou aryle.

**12.** Procédé selon la revendication 11, caractérisé en ce que le composé de formule générale II est la 2-(2'-hydroxy-4'-méthoxy-styryl)-4,6-bis-(trichlorométhyl)-s-triazine.

**13.** Procédé selon l'une des revendications 7 ou 9, caractérisé en ce que, dans la formule générale II, $R^8$ représente un groupe aryle éventuellement substitué.

**14.** Procédé selon l'une des revendications 1 à 4 et 7 à 13, caractérisé en ce que le composé de formule générale I est la benzophénone ou un dérivé de la benzophénone.

**15.** Procédé selon l'une des revendications 1 à 4 et 7 à 13, caractérisé en ce que le composé de formule générale I est la cétone de Michler.

**16.** Procédé selon l'une des revendications 1 à 2 et 5 à 13, caractérisé en ce que le composé de formule générale I est la thioxanthone ou un dérivé de la thioxanthone.

**17.** Procédé selon l'une des revendications 1 à 2 et 5 à 13, caractérisé en ce que le composé de formule générale I est la 2-chlorothioxanthone.

**18.** Procédé selon l'une des revendications 1 à 10 et 13 à 17, caractérisé en ce que le composé de

formule générale II est une 2-aryl-4,6-bis-(trichlorométhyl)-s-triazine.

**19.** Procédé selon l'une des revendications 1 à 15, caractérisé en ce que le photo-inducteur contient de 10 à 40 % en poids du composant a) et de 90 à 60 % en poids du composant b), dans les deux cas par rapport à la somme des composants a) + b).

**20.** Procédé selon l'une des revendications 1 à 19, caractérisé en ce que l'inducteur de photopolymérisation est contenu en quantité de 0,5 à 15 % du poids du mélange photopolymérisable total, à raison de 0,1 à 5 % en poids, par rapport au mélange photopolymérisable total, du composant a), et de 0,4 à 10 % en poids, par rapport au mélange photopolymérisable total, du composant b).

**21.** Procédé selon l'une des revendications 1 à 20, caractérisé en ce que la couche d'enregistrement photopolymérisable de l'élément d'enregistrement photosensible a une épaisseur dans l'intervalle de 0,1 à 50 µm.

**22.** Procédé selon l'une des revendications 1 à 21, pour la préparation de formes d'impression à plat, caractérisé en ce que l'élément d'enregistrement photosensible a un support typique pour plaques d'impression à plat et en ce que l'épaisseur de la couche d'enregistrement photopolymérisable se situe dans l'intervalle de 0,5 à 8 µm.

**23.** Procédé selon l'une des revendications 1 à 22, caractérisé en ce que la couche d'enregistrement photopolymérisable est constituée d'un mélange photopolymérisable homogène consistant lui-même en 0,5 à 15 % en poids de l'inducteur de photopolymérisation formé des composants a) et b), 8 à 65 % en poids d'au moins un monomère à insaturation éthylénique photopolymérisable, 30 à 90 % en poids d'au moins un liant polymère compatible avec les monomères et non photopolymérisable ni photoréticulable, et 0 à 25 % en poids d'additifs et/ou produits auxiliaires, toutes les indications de pourcentage se rapportant au mélange photopolymérisable total.

**24.** Procédé selon l'une des revendications 1 à 22, caractérisé en ce que la couche d'enregistrement photopolymérisable est constituée d'un mélange homogène photopolymérisable consistant lui-même en 0,5 à 15 % en poids de l'inducteur de photopolymérisation formé des composants a) et b), 70 à 99,5 % en poids d'au moins un oligomère à insaturation éthylénique photopolymérisable, de poids moléculaire moyen (moyenne en nombre) dans l'intervalle de 1000 à 10 000, qui contient dans la molécule des groupes carboxyle libres et au moins deux radicaux contenant des groupes acryloyle et/ou méthacryloyle, 0 à 10 % en poids d'au moins un monomère à insaturation éthylénique photopolymérisable compatible avec les oligomères, 0 à 10 % en poids d'au moins un liant polymère compatible avec les oligomères et les monomères éventuellement présents, non photopolymérisable ni photoréticulable, et 0 à 10 % en poids d'additifs et/ou produits auxiliaires.

**25.** Procédé selon la revendication 24, caractérisé en ce que l'on utilise au moins un oligomère à insaturation éthylénique photopolymérisable de poids moléculaire moyen (moyenne en nombre) dans l'intervalle de 1000 à 10 000, contenant dans la molécule des groupes carboxyle libres et plus de deux radicaux contenant des groupes acryloyle et/ou méthacryloyle.

**26.** Procédé selon la revendication 24 ou 25, caractérisé en ce que les oligomères contenus dans la couche d'enregistrement photopolymérisable sont des résines d'uréthannes oligomères contenant des groupes (méth)acryloyle, telles qu'on peut les obtenir par réaction de diols ou polyols contenant des groupes (méth)acryloyle avec un diisocyanate, éventuellement en présence de diols à bas poids moléculaire servant d'agents d'allongement des chaînes, avec réaction partielle des groupes hydroxy du diol ou du polyol et formation d'une résine d'uréthanne oligomère contenant des groupes hydroxy, suivie de la réaction complète ou partielle des groupes hydroxy encore libres dans la résine d'uréthannne avec un anhydride d'acide dicarboxylique cyclique, avec formation de l'ester partiel acide de l'acide dicarboxylique.

**27.** Procédé selon l'une des revendications 1 à 22, caractérisé en ce que la couche d'enregistrement photopolymérisable est constituée d'un mélange homogène photopolymérisable consistant lui-même en 0,5 à 15 % en poids de l'inducteur de photopolymérisation formé des composants a) et b), 75 à 99,5 % en poids d'un mélange de composés à insaturation éthylénique photopolymérisables ou photoréticulables et 0 à 10 % en poids d'additifs et/ou produits auxiliaires, toutes les indications de pourcentage se rapportant au mélange photopolymérisable total, et le mélange des composés à insaturation éthylénique photopolymérisables est constitué d'au moins un monomère à insaturation éthylénique photopolymérisable et d'au moins un polymére compatible avec les monomères, photopolymérisable ou photoréticulable, les proportions relatives en poids entre les monomères photopolymérisable et le polymère photopolymérisable ou photoréticulable se situant dans l'intervalle de 1:15 à 1:1.